# EUROPEAN PATENT APPLICATION

(11) **EP 1 721 880 A1**
(43) Date of publication of application: **15.11.2006**
(21) Application number: 05709838.6
(22) Date of filing: 07.02.2005
(51) Int. Cl.: C04B 41/90, C04B 41/88, H01L 35/34

(54) **METALLIZED CERAMIC MOLDING, PROCESS FOR PRODUCING THE SAME AND PELTIER DEVICE**

(30) Priority: 09.02.2004 JP 2004031627; 12.02.2004 JP 2004034873
(71) Applicant: TOKUYAMA CORPORATION, Shunana-shi, Yamaguchi 745-8648 (JP); The circle for the promotion of science and engineering, Tokyo, 1528550 (JP)
(72) Inventor: FUKUYAMA, Hiroyuki c/o Inst. Multidisciplinary, Sendai-shi, Miyagi 9808577 (JP); YONEDA, Takehiko, Shunan-shi, Yamaguchi 7458648 (JP); KIKUTANI, Shingo, Shunan-shi, Yamaguchi 7458648 (JP)
(74) Representative: Kador & Partner
(86) International application number: PCT/JP2005/001786
(87) International publication number: WO 2005/075382

(57) **Abstract**

[PROBLEMS] To provide a metallized non-oxide ceramic shaped article having high adhesive strength between a metal layer and a substrate and the adhesion durability and to provide a process for producing the same.

[MEANS FOR SOLVING PROBLEMS] The process for producing a metallized shaped article includes: a heating step of heating a non-oxide ceramic shaped article to a temperature at or above a temperature, which is 300°C below the oxidation start temperature of the non-oxide ceramics, without substantial dissolution of oxygen in a solid solution form during heating; an oxidation step of bringing the non-oxide ceramic substrate heated in the heating step into contact with an oxidizing gas and then holding the non-oxide ceramic substrate at a temperature above the oxidation start temperature of the non-oxide ceramics to oxidize the surface of the non-oxide ceramic shaped article and thus to form an oxide layer on the surface of the non-oxide ceramic substrate; and a metallization step of forming a metal layer on the surface of the oxide layer in the non-oxide ceramic shaped article having an oxide layer on its surface produced in the oxidation step.

## Description

### TECHNICAL FIELD

The present invention relates to a metallized ceramic shaped article comprising a metallized layer provided on the surface of a shaped article of a non-oxide ceramics such as aluminum nitride or silicon nitride, and a process for producing the same.
The present invention also relates to a Peltier element for cooling or heating utilizing a thermoelectric effect of a thermoelectric material.

### BACKGROUND ART

Non-oxide ceramics such as aluminum nitride and silicon nitride have excellent features such as high thermal conductivity and high thermal shock resistance and thus have been widely used as materials for ceramic heaters (comprising a metal as a heating resistor bonded to the surface or inside of a ceramic shaped article), or materials for various electronic circuit substrates such as submounts for semiconductor element mounting and substrates for power modules. Further, Peltier elements are one of applications of such non-oxide ceramics.

Peltier elements have a structure comprising P-type thermoelectric materials and N-type thermoelectric materials, which are alternately arranged in series through metal electrodes, and, upon energization, develop a cooling/heat generation effect called "Peltier effect" at a bond part between the P-type thermoelectric material and the N-type thermoelectric material. In the Peltier element, in order to ensure the mechanical strength of the whole element, a thermoelectric material member comprising an array of thermoelectric materials and metal electrodes is generally held and fixed between two opposed ceramic substrates.

Non-oxide ceramic substrates such as aluminum nitride substrates are in many cases used as the ceramic substrate because of their high thermal conductivity. The thermoelectric material member is generally fixed onto the non-oxide ceramic substrate by soldering the electrode to the substrate. To this end and to supply a working current to the thermoelectric material, a conductor pattern is provided on the surface of the ceramic substrate. In general, a relatively large current is allowed to flow into the Peltier element, and, thus, the conductor pattern should be formed of a relatively thick film of a metal having a low electrical resistance such as Cu. Methods for the formation of a conductor pattern on a ceramic substrate include a method in which a conductor pattern is formed on a roughened ceramic substrate by a combination of electroless copper plating with electric copper plating (see patent document 1), a method in which a copper film bonded by a DBC (direct bonding copper) method is patterned by photolithoetching (see patent document 2), and a method in which, after the formation of a metallic thin film layer having copper on its upper surface by sputtering or the like, a copper layer is plated thereon (see patent document 3).

Likewise, when the non-oxide ceramic shaped article (particularly substrate) is used as a ceramic heater or a substrate for an electronic circuit, a metal layer is formed on the surface to form an electrode or a circuit pattern. Unlike the oxide ceramics such as alumina, however, the adhesion of the non-oxide ceramics to the metal is generally low, and, thus, in the formation of a metal layer on the surface of a nitride ceramic shaped article, an effort has been made to improve the adhesion between the non-oxide ceramics and the metal layer depending upon the metallization method.

For example, when a metallic thin film is formed, for example, by sputtering or vapor deposition (the so-called "thin film formation method"), a commonly adopted method comprises forming a metal layer having high adhesion such as Ti (titanium) on the surface of a nitride ceramic shaped article and then forming a layer formed of a highly electrically conductive metal such as platinum or gold on the metal layer (see patent document 4). Further, when a copper plate or a copper foil is bonded directly to the surface of the nitride ceramics, a DBC method has been adopted. In the DBC method, after the oxidation of the surface of the nitride ceramic shaped article, an oxide layer is formed followed by burning a copper plate or a copper foil into the surface (see patent document 5). In this method, since a copper plate or a copper foil is baked after the oxidation of the surface of an alminum nitride article to form an oxide (alumina) layer, relatively good bonding can be provided by an Al₂O₃-Cu₂O layer produced at that time. Further, regarding the formation of a circuit pattern by printing a circuit pattern on the surface of a shaped article using a metal component-containing paste and firing the print (the so-called "thick film formation method"), a method has been proposed in which, after the oxidation of a nitride ceramics, an alumina-silicon oxide vapor deposited layer is formed thereon and, further, a paste is applied thereonto (see patent document 6).

Among them, the method using the DBC method and the method in which plating is carried out after thin film formation have been adopted when an aluminum nitride sintered body having particularly high thermal conductivity is used as the ceramic shaped article.

These methods, however, are not always satisfactory in the adhesive strength between the metal layer and the substrate in the metallized ceramic shaped article, or the adhesion durability.
In particular, in the Peltier element, upon operation, one of the ceramic substrates is heated while the other substrate is cooled. Due to this fact, a large difference in temperature occurs between both the substrates, and the difference in thermal expansion causes the development of stress at the bonded part between the metal electrode and the ceramic substrate. When the copper film is bonded by the DBC method, however, the adhesive strength between the copper film and the ceramic substrate is not always satisfactory. Therefore, in a Peltier element using a ceramic substrate metallized by the DBC method, in some cases, the metal electrode is disadvantageously separated during long-term use.

Further, the resistance of aluminum nitride to water or an aqueous alkaline solution is so low that, when metallization is carried out by plating after thin-film formation, some plating conditions pose problems such as damage to the ceramic shaped article as the base material during plating, or a plating-derived lowering in adhesive strength of the metal layer. Oxidation of the surface of aluminum nitride is known as means for enhancing the water resistance and chemical resistance of aluminum nitride (see patent document 7). The effect of this means, however, is not satisfactory.

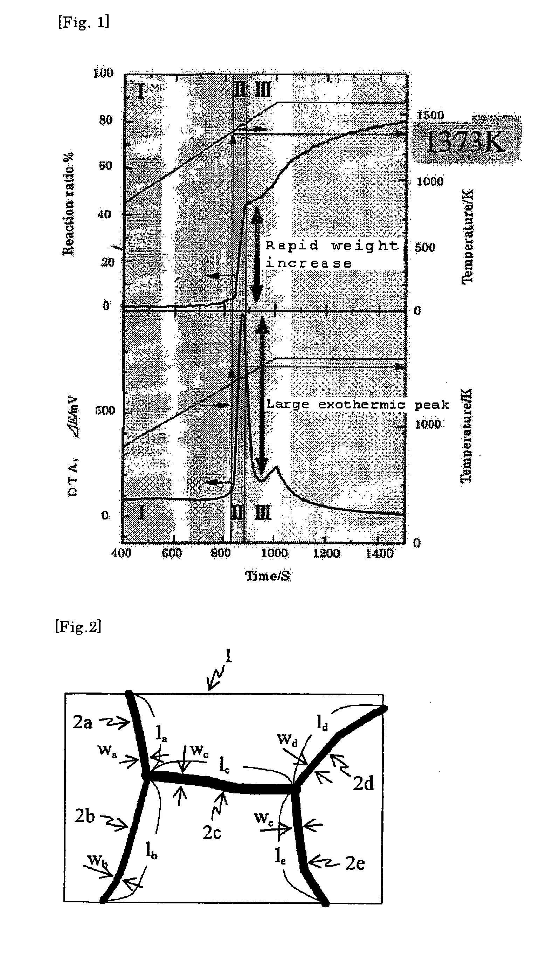

The present inventors have considered that, in order to improve the water resistance of aluminum nitride, they should find out an oxidation mechanism of the non-oxide ceramics. To this end, studies for elucidating the oxidation mechanism have been made using an aluminum nitride powder. As a result, it has been found that oxidation caused upon heating of the aluminum nitride powder in an oxygen gas proceeds through three stages as shown in Fig. 1. Specifically, Fig. 1 shows a change in reaction rate with the elapse of time in an experiment where an aluminum nitride powder is heated in an oxygen atmosphere at a temperature rise rate of 75°C/min. In a graph in the upper part, the time (sec) is plotted as abscissa against the reaction rate (%) measured by a thermogravimetric analysis and the temperature (K) corresponding to the temperature rise pattern as ordinate. In a graph in the lower part, the time (sec) is plotted as abscissa against DTA (ΔE/mV) showing calorific value measured by a differential thermal analysis and the temperature (K) corresponding to the temperature rise pattern as ordinate. The graphs in Fig. 1 can be divided into three stages of I to III. Stage I is a stage corresponding to a period in which aluminum nitride is heated from room temperature to 1100°C (1373 K). What takes place in this stage is only the dissolution of oxygen in aluminum nitride to form a solid solution, and, in this state, oxidation hardly occurs. In the stage II where the temperature reached about 1100°C, the oxygen in the solid solution form is reacted at a breath and consequently is converted to Al₂O₃ (α-alumina), whereby a rapid weight increase and significant heat generation take place. In the stage III which is a stage after the rapid reaction has been cooled down, the reaction proceeds slowly in an oxygen diffusion controlled manner.
From the above oxidation mechanism, it has been found that, in order to form a dense oxide film on aluminum nitride, a method is effective in which aluminum nitride is heated in nitrogen to 1100°C while avoiding the dissolution of oxygen in a solid solution form and, in this state, the atmosphere is replaced by oxygen for oxidation (hereinafter referred to also as "novel oxidation process," and that, when this method is adopted, the oxide film can be formed without a substantial change in surface state of the aluminum nitride powder (see non-patent document 1).
Patent document 1: Japanese Patent Laid-Open No. 263882/1991 Patent document 2: Japanese Utility Model Laid-Open No. 20465/1988
Patent document 3: Japanese Patent Laid-Open No. 017837/2003
Patent document 4: Patent No. 2563809
Patent document 5: Japanese Patent Laid-Open No. 214080/1992
Patent document 6: Japanese Patent Laid-Open No. 223883/1995
Patent document 7: Japanese Patent Laid-Open No. 272985/2000
Non-patent document 1: Hiroyuki Fukuyama et al., Proceedings of the 2002. SIGEN SOZAI GAKKAI p. 351-352 (published on September 23, 2002)

### DISCLOSURE OF THE INVENTION

### PROBLEMS TO BE SOLVED BY THE INVENTION

However, an aluminum nitride powder is the only material which has been confirmed that a good oxide film can be formed by the novel oxidation process. For shaped articles such as substrates, whether or not the same effect can be attained, is unknown. When a shaped article such as a substrate is oxidized, unlike the case where an oxide film is formed on the surface of each powder particle, an oxide film should be formed on the whole continuous large-area plane. Accordingly, it is considered that, in forming an oxide layer, a higher level of stress is produced, possibly leading to the occurrence of cracking. Further, in the non-patent document 1, the oxidized aluminum nitride powder is evaluated only by the microscopic observation of the surface state, and the water resistance, chemical resistance, and adhesion to metals are not evaluated.

Specifically, whether or not the novel oxidation process is effective for solving the above problems involved in the conventional aluminum nitride metallized shaped articles or Peltier elements using them, are unknown, and these problems have remained unsolved.
Accordingly, an object of the present invention is to provide a metallized non-oxide ceramic shaped article (particularly a substrate) having high metal layer-substrate adhesive strength and adhesion durability and a metallized non-oxide ceramic shaped article (particularly a substrate) that, even when subjected to plating treatment, does not undergo a lowering in the bonding strength of the metal layer by virtue of its excellent water resistance and chemical resistance. Another object of the present invention is to provide a process for producing a Peltier element using the above metallized non-oxide ceramic shaped article and, consequently, to provide a Peltier element having excellent durability.

### MEANS FOR SOLVING THE PROBLEMS

In order to attain the above objects, the present inventors have applied, to an aluminum nitride sintered substrate rather than powder, the above novel oxidation process, that is, a process which comprises heating the aluminum nitride shaped article in an oxidizing gas-free atmosphere until the temperature reaches a value at which an oxidation reaction of aluminum nitride starts rapidly (a reaction start temperature) and, upon arrival at the reaction start temperature, bringing the aluminum nitride shaped article and an oxidizing gas into contact with each other to oxidize the aluminum nitride shaped article, and the present inventors have evaluated the "aluminum nitride substrate having an oxide layer on its surface" (surface oxidized AlN substrate).

As a result, they confirmed that, also for the shaped article like the substrate, the oxide film free from the above-described large crack can be formed by the new oxidation process and the aluminum nitride shaped article having this oxide film has high water resistance and chemical resistance (Japanese Patent Laid-Open No. 91319/2004, priority date: August 15, 2002, laid-open date: March 25, 2004) .

The present inventors have examined in detail the structure of the oxide layer in various "surface oxidized AlN substrates" produced by the new oxidation process under varied conditions, and studies have been made on adhesion to metals; water resistance and chemical resistance; and durability of the adhesion to metals and water resistance and chemical resistance. As a result, they have obtained the following finding (1) to (5).
(1) The surface oxidized AlN substrate produced by the new oxidation process is superior, to the surface oxidized AlN substrate produced by the conventional oxidation process involving heating for heating of the substrate in the air to form an oxide film, in water resistance and chemical resistance, as well as in bonding to metals.
(2) As a result of detailed analysis of "a non-oxide ceramics having an oxide layer on its surface" produced by the conventional oxidation process or by some new oxidation process, it was found that voids are formed in the oxide layer in its part around the boundary of the oxide layer and the non-oxide ceramics.
(3) In the new oxidation process, when a method is adopted in which, before heat treatment, degassing treatment, in which the inside of a furnace containing an aluminum nitride shaped article is vacuum degassed, is carried out, and an ultrapure inert gas is introduced into the furnace followed by the start of heating, whereby the influence of gas released from the aluminum nitride shaped article and the furnace material is eliminated as much as possible to closely regulate the concentration of moisture and oxygen contained in the atmosphere at the time of heating of the aluminum nitride sintered substrate and, in addition, when the pressure of the oxidizing gas in an early stage of the oxidation reaction is regulated in a specific range, it was found that the resultant "aluminum nitride shaped article having an oxide film on its surface" has a macrostructural feature that the characteristic cracks which will be described later, are not observed in the oxide film and further has a microstructural feature that the region around the boundary of the aluminum nitride shaped article and the oxide film is free from voids.
(4) The surface oxidized AlN substrate produced under conditions described in the above item (3) in the new oxidation process has particularly high adhesion between the aluminum nitride substrate and the oxide layer, has high water resistance, chemical resistance, and adhesion to metals, and, at the same time, is very high in their durability, particularly durability against heat cycle.
(5) The above phenomenon can be applied not only to the aluminum nitride shaped article but also to shaped articles of other non-oxide ceramics such as nitride ceramics and carbide ceramics.
   The present invention has been made based on such finding.

The subject matters ([1] to [11]) of the present invention, which can attain the above objects of the present invention, will be summarized below.
[1] A process for producing a metallized ceramic shaped article, comprising: a heating step of heating a non-oxide ceramic shaped article to a temperature at or above a temperature, which is 300°C below the oxidation start temperature of the non-oxide ceramics, without substantial dissolution of oxygen in a solid solution form during heating; an oxidation step of bringing the non-oxide ceramic shaped article heated in the heating step into contact with an oxidizing gas and then holding the non-oxide ceramic shaped article at a temperature above the oxidation start temperature of the non-oxide ceramics to oxidize the surface of the non-oxide ceramic shaped article and thus to form an oxide layer on the surface of the non-oxide ceramic shaped article; and a metallization step of forming a metal layer on the surface of the oxide layer in the non-oxide ceramic shaped article having an oxide layer on its surface produced in the oxidation step.
[2] The method according to the above item [1], wherein the heating step comprises the steps of:
   (I) introducing the non-oxide ceramic shaped article into a furnace, then discharging an oxidizing substance adsorbed or sorbed to the non-oxide ceramic shaped article and to a furnace material outside of the furnace, so as to regulate an oxidizing gas content in the atmosphere within the furnace to be not more than 0.5 mmol in terms of total number of moles of the oxidizing gas per m³ of the inside of the furnace; and
   (II) heating the non-oxide ceramic shaped article to a temperature at or above a temperature, which is 300°C below the oxidation start temperature of the non-oxide ceramics, while maintaining the atmosphere in the furnace having an oxidizing gas content of not more than 0.5 mmol in terms of total number of moles of the oxidizing gas per m³ of the inside of the furnace; and wherein
      when bringing the non-oxide ceramic shaped article into contact with the oxidizing gas in the oxidation step, until at least 2 min. elapses after the arrival of the temperature of the non-oxide ceramic shaped article at or above the oxidation start temperature thereof, the pressure or partial pressure of the oxidizing gas is maintained at not more than 50 kPa.
[3] The process according to the above items [1] or [2], wherein the metallization step comprises plating treatment.
[4] A metallized ceramic shaped article produced by the method of any one of items [1] to [3].
[5] A metallized ceramic shaped article comprising:
   a ceramic shaped article comprising a non-oxide ceramic shaped article composed mainly of a nitride or carbide of a metal or semimetal and an oxide layer formed of an oxide of an element identical to the metal or semimetal element provided on the surface of the non-oxide ceramic shaped article; and a metal layer provided on the oxide layer, wherein, when a branched crack is divided into a crack unit located between adjacent branch points and crack units extending from the crack end to the nearest branch point, a branched crack having a crack unit simultaneously meeting a "w" value of not less than 20 nm, an "l" value of not less than 500 nm and a "w/l" value of not less than 0.02, wherein "l" (nm) represents the length of each crack unit, and "w" (nm) represents the maximum width of each crack unit, is substantially absent on the surface of the oxide layer.
[6] A metallized ceramic shaped article comprising: a ceramic shaped article comprising a non-oxide ceramic shaped article composed mainly of a nitride or carbide of a metal or semimetal and a 0.1 to 100 µm-thick oxide layer formed of an oxide of an element identical to the metal or semimetal element provided on the surface of the non-oxide ceramic shaped article; and a metal layer provided on the oxide layer, wherein voids are substantially absent in the oxide layer in its region in a thickness of at least 20 nm from the boundary of the non-oxide ceramic layer and the oxide layer.
[7] A Peltier element comprising: a pair of ceramic substrates each having a conductor pattern on its surface and disposed so as to face each other; a thermoelectric material part comprising P-type thermoelectric materials and N-type thermoelectric materials arranged alternately between the pair of ceramic substrates; an electrode disposed between the thermoelectric material part and one of the ceramic substrates; and an electrode disposed between the thermoelectric material part and the other ceramic substrate, said electrodes being disposed so that the P-type thermoelectric materials and N-type thermoelectric materials constituting the thermoelectric material part are alternately connected electrically, said electrodes being each connected electrically to the conductor pattern in the adjacent ceramic substrate, wherein
   the ceramic substrate comprises: a non-oxide ceramic substrate composed mainly of a nitride or carbide of a metal or semimetal and an oxide layer formed of an oxide of an element identical to the metal or semimetal element provided on the surface of the non-oxide ceramic substrate, and, when a branched crack is divided into a crack unit located between adjacent branch points and crack units extending from the crack end to the nearest branch point, a branched crack having a crack unit simultaneously meeting a "w" value of not less than 20 nm, an "l" value of not less than 500 nm and a "w/l" value of not less than 0.02, wherein "l" (nm) represents the length of each crack unit, and "w" (nm) represents the maximum width of each crack unit, is substantially absent on the surface of the oxide layer.
[8] A Peltier element comprising: a pair of ceramic substrates each having a conductor pattern on its surface and disposed so as to face each other; a thermoelectric material part comprising P-type thermoelectric materials and N-type thermoelectric materials arranged alternately between the pair of ceramic substrates; an electrode interposed between the thermoelectric material part and one of the ceramic substrates; and an electrode interposed between the thermoelectric material part and the other ceramic substrate, said electrodes being disposed so that the P-type thermoelectric materials and N-type thermoelectric materials constituting the thermoelectric material part are alternately connected electrically, said electrodes being each connected electrically to the conductor pattern in the adjacent ceramic substrate, wherein
   the ceramic substrate comprises: a ceramic substrate comprising a non-oxide ceramic substrate composed mainly of a nitride or carbide of a metal or semimetal; and a 0.1 to 100 µm-thick oxide layer formed of an oxide of an element identical to the metal or semimetal element provided on the surface of the non-oxide ceramic substrate, and voids are substantially absent in the oxide layer in its region in a thickness of at least 20 nm from the boundary of the non-oxide ceramic layer and the oxide layer.
[9] A process for producing a Peltier element, said Peltier element comprising: a pair of ceramic substrates each having a conductor pattern on its surface and disposed so as to face each other; a thermoelectric material part comprising P-type thermoelectric materials and N-type thermoelectric materials arranged alternately between the pair of ceramic substrates; an electrode interposed between the thermoelectric material part and one of the ceramic substrates; and an electrode interposed between the thermoelectric material part and the other ceramic substrate, the electrodes being disposed so that the P-type thermoelectric materials and N-type thermoelectric materials constituting the thermoelectric material part are alternately connected electrically, the electrodes being each connected electrically to the conductor pattern in the adjacent ceramic substrate, said process comprising the following steps A, B, and C,
   step A: a step of providing a thermoelectric material member comprising alternately arranged P-type thermoelectric materials and N-type thermoelectric materials, wherein the top face of each of the thermoelectric materials is connected electrically to the top face of the thermoelectric material adjacent to one side thereof through an electrode, and, at the same time, the bottom face of each of the thermoelectric materials is connected electrically to the bottom face of the thermoelectric material adjacent to the other side thereof through an electrode,
   step B: a step of providing a pair of ceramic substrates each having a conductor pattern on its surface, the conductor pattern in each of the ceramic substrates being provided so that, when the thermoelectric material member is held between the ceramic substrates, the conductor pattern is connected electrically to the electrode in the thermoelectric material member, and
   step C: a step of disposing the thermoelectric material member between the pair of ceramic substrates and soldering the electrodes in the thermoelectric material member to the conductor pattern in each of the ceramic substrates, wherein
      said process further comprising the following steps for the production of the ceramic substrates having a conductor pattern on the surface thereof,
   step D: a heating step of heating a non-oxide ceramic substrate to a temperature at or above a temperature, which is 300°C below the oxidation start temperature of the non-oxide ceramics, without substantial dissolution of oxygen in a solid solution form during heating;
   step E: an oxidation step of bringing the non-oxide ceramic substrate heated in the step D into contact with an oxidizing gas and then holding the non-oxide ceramic substrate at a temperature above the oxidation start temperature of the non-oxide ceramics to oxidize the surface of the non-oxide ceramic substrate and thus to form an oxide layer on the surface of the non-oxide ceramic substrate; and
   step F: a step of forming a pattern of copper or a metal layer composed mainly of copper on the oxide layer in the non-oxide ceramic substrate having an oxide layer on its surface produced in the step E by a thick-film forming method and then forming a layer of a metal different from the metal constituting the metal layer by a plating method onto the pattern.
[10] A Peltier element comprising: a pair of ceramic substrates each having a conductor pattern on its surface and disposed so as to face each other; a thermoelectric material part comprising P-type thermoelectric materials and N-type thermoelectric materials arranged alternately between the pair of ceramic substrates; an electrode disposed between the thermoelectric material part and one of the ceramic substrates; and an electrode disposed between the thermoelectric material part and the other ceramic substrate, said first and second electrodes being disposed so that the P-type thermoelectric materials and N-type thermoelectric materials constituting the thermoelectric material part are alternately connected electrically, said electrodes being each connected electrically to the conductor pattern in the adjacent ceramic substrate, wherein
   the ceramic substrate is "a non-oxide ceramic substrate having an oxide layer on its surface" produced by a process comprising the following steps D and E,
   step D: a heating step of heating a non-oxide ceramic substrate to a temperature at or above a temperature, which is 300°C below the oxidation start temperature of the non-oxide ceramic, without substantial dissolution of oxygen in a solid solution form during heating; and
   step E: an oxidation step of bringing the non-oxide ceramic substrate heated in the step D into contact with an oxidizing gas and then holding the non-oxide ceramic substrate at a temperature above the oxidation start temperature of the non-oxide ceramic to oxidize the surface of the non-oxide ceramic substrate and thus to form an oxide layer on the surface of the non-oxide ceramic substrate.
[11] The Peltier element according to the above [10], wherein the step D comprises the steps of:
   (I) introducing the non-oxide ceramic shaped article into a furnace, then discharging an oxidizing substance adsorbed or sorbed to the non-oxide ceramic substrate and to a furnace material outside of the furnace, so as to regulate an oxidizing gas content in the atmosphere within the furnace to be not more than 0.5 mmol in terms of total number of moles of the oxidizing gas per m³ of the inside of the furnace; and
   (II) heating the non-oxide ceramic substrate to a temperature at or above a temperature, which is 300°C below the oxidation start temperature of the non-oxide ceramics, while maintaining the atmosphere in the furnace having an oxidizing gas content of not more than 0.5 mmol in terms of total number of moles of the oxidizing gas per m³ of the inside of the furnace; and
      when bringing the non-oxide ceramic substrate into contact with the oxidizing gas in the oxidation step E, until at least 2 min. elapses after the arrival of the temperature of the non-oxide ceramic shaped article at or above the oxidation start temperature thereof, the pressure or partial pressure of the oxidizing gas is maintained at not more than 50 kPa.

### EFFECT OF THE INVENTION

In the metallized shaped article according to the present invention, the oxide layer in the "non-oxide ceramic shaped article having an oxide layer on its surface" as a layer underlying the metal layer has very high quality, and, thus, the adhesion between the metal layer and the ceramic shaped article is very high. Further, metallization techniques in oxide ceramics are also applicable. Therefore, as compared with the conventional non-oxide ceramic metallized shaped article, the reliability in the use of the metallized shaped article as ceramic heaters or electronic circuit boards is significantly improved. Further, according to the production process of the present invention, the above metallized shaped article according to the present invention can be produced stably with high efficiency.

The Peltier element according to the present invention uses a non-oxide ceramic substrate having a high-quality oxide layer on its surface. Therefore, the Peltier element is characterized in that, despite the fact that the substrate is composed mainly of a non-oxide ceramics, the adhesion between the metal layer constituting a conductor pattern and the substrate is very good. Further, when the oxidation treatment is carried out under specific conditions, durability of these properties against heat cycle is excellent. Further, since the oxide layer functions also as a protective layer, even when a plating method is applied, neither damage to or a deterioration in the substrate nor a plating-derived lowering in adhesive strength of the metal layer occurs. Therefore, regarding the Peltier element according to the present invention, in producing this element, more specifically in producing a ceramic substrate having a conductor pattern (a metallized substrate), a novel metallization process can be adopted in which a conductor circuit pattern is formed using a copper thick-film paste by a printing method and a metal layer as a layer of barrier against a solder layer is further formed thereon by a plating method.

Further, since the novel metallization process adopts a thick-film formation method and a plating method which are simple in operation and low in cost, the production process according to the present invention using the metallization process can provide a Peltier element simply at low cost.

### BRIEF DESCRIPTION OF THE DRAWINGS

[Fig. 1] Fig. 1 is a graph showing a reaction rate and a DTA change pattern when an aluminum nitride substrate is heated in an oxygen atmosphere.
[Fig. 2] Fig. 2 is a diagram illustrating specific cracks.
[Fig. 3] Fig. 3 is a SEM photograph of the surface of an oxide layer in an aluminum nitride substrate having an oxide layer on its surface produced by the step of oxidation in Example 1.
[Fig. 4] Fig. 4 is a sketch of the SEM photograph shown in Fig. 3.
[Fig. 5] Fig. 5 is a SEM photograph of the surface of an oxide layer in an aluminum nitride substrate having an oxide layer on its surface produced by the step of oxidation in Example 2.
[Fig. 6] Fig. 6 is a sketch of the SEM photograph shown in Fig. 5.
[Fig. 7] Fig. 7 is a TEM photograph of the cross-section of an oxide layer in an aluminum nitride substrate having an oxide layer on its surface produced by the step of oxidation in Example 1.
[Fig. 8] Fig. 8 is a sketch of the TEM photograph shown in Fig. 7.
[Fig. 9] Fig. 9 is a TEM photograph of the cross-section of an oxide layer in an aluminum nitride substrate having an oxide layer on its surface produced by the step of oxidation in Example 2.
[Fig. 10] Fig. 10 is a sketch of the TEM photograph shown in Fig. 9.
[Fig. 11] Fig. 11 is a SEM photograph of the surface of an oxide layer in an aluminum nitride substrate having an oxide layer on its surface produced by the step of oxidation in Comparative Example 1.
[Fig. 12] Fig. 12 is a sketch of the SEM photograph shown in Fig. 11.
[Fig. 13] Fig. 13 is a SEM photograph of the surface of an oxide layer in an aluminum nitride substrate having an oxide layer on its surface produced by the step of oxidation in Comparative Example 2.
[Fig. 14] Fig. 14 is a sketch of the SEM photograph shown in Fig. 13.
[Fig. 15] Fig. 15 is a TEM photograph of the cross-section of an oxide layer in an aluminum nitride substrate having an oxide layer on its surface produced by the step of oxidation in Comparative Example 1.
[Fig. 16] Fig. 16 is a sketch of the TEM photograph shown in Fig. 15.
[Fig. 17] Fig. 17 is a TEM photograph of the cross-section of an oxide layer in an aluminum nitride substrate having an oxide layer on its surface produced by the step of oxidation in Comparative Example 2.
[Fig. 18] Fig. 18 is a sketch of the TEM photograph shown in Fig. 17.
[Fig. 19] Fig. 19 is a cross-sectional view of a typical Peltier element according to the present invention.
[Fig. 20] Fig. 20 is a partially enlarged cross-sectional view of a typical Peltier element according to the present invention.

### DESCRIPTION OF REFERENCE CHARACTERS

- 1: branched cracks
- 2a to 2e: crack units
- 1ₐ to 1ₑ: each crack unit length
- wₐ to wₑ: maximum width of each crack unit
- 100: Peltier element
- 200a, b: non-oxide ceramic substrate having specific oxide layer on its surface
- 300: thermoelectric material member
- 310: P-type thermoelectric material
- 320: N-type thermoelectric material
- 330a, b: solder layer
- 340a, b: electrode
- 400a, b: metal layer constituting conductor circuit pattern
- 500a, b: (second) solder layer
- 600a, b: heat transfer material

### BEST MODE FOR CARRYING OUT THE INVENTION

In the production process of the present invention, a non-oxide ceramic shaped article (hereinafter referred to simply also as "object ceramic shaped article") is first heated to a temperature at or above a temperature, which is 300°C below the oxidation start temperature of the non-oxide ceramics (hereinafter referred to simply as "object ceramics") constituting the shaped article, without substantial dissolution of oxygen in a solid solution form during heating (heating step).

In the conventional oxidation process in which the atmosphere at the time of heating is an atmosphere containing a large amount of oxygen, for example, the oxygen is dissolved in the non-oxide ceramic to form a solid solution in the course of raising temperature, and, when the base material temperature reaches the reaction start temperature of the oxidation reaction, the oxygen in the solid solution form is reacted rapidly. As a result, due to rapid occurrence of stress attributable, for example, to a difference in lattice constant between the underlying material and the oxide layer, the occurrence of specific cracks in the oxide layer is unavoidable. That is, when a branched crack is divided into a crack unit located between adjacent branch points and crack units extending from the crack end to the nearest branch point, the occurrence of a branched crack having a crack unit simultaneously meeting a "w" value of not less than 20 nm, an "1" value of not less than 500 nm and a "w/l" value of not less than 0.02, wherein "1" (nm) represents the length of each crack unit, and "w" (nm) represents the maximum width of each crack unit is unavoidable. By contrast, in the process according to the present invention, during heating, the dissolution of oxygen in a solid solution form which poses a problem does not occur, and, after the temperature reaches the reaction start temperature, the oxidation reaction of the base material gradually proceeds in an oxygen diffusion controlled manner. Therefore, specific cracks are not formed even when the non-oxide ceramics to be oxidized is a shaped article such as a substrate. In the formation of an oxide film by the process according to the present invention, when the thickness of the formed film is large, cracking sometimes takes place. The cracks in this case have a small width, and the degree of branching is also small. Further, the number of cracks(the number of cracks per unit area) is much smaller than the number of cracks in the conventional technique.

In the process according to the present invention, when the atmosphere in the heating step (atmosphere during heating) is brought to an inert gas atmosphere such as a nitrogen gas atmosphere, the dissolution of oxygen in the base material in a solid solution form during heating can be prevented and the occurrence of the above specific cracks can be prevented at the time of oxidation, whereby "a non-oxide ceramic shaped article having an oxide layer on its surface" which has excellent water resistance, chemical resistance, and bondability to metals (hereinafter often referred to simply as "surface oxidized shaped article") can be provided.

When the total concentration of the oxidizing gas contained in the inert gas exceeds 0.5 mmol/m³ (0.00112% by volume) , however, voids are disadvantageously formed in the oxide layer around the boundary of the oxide layer and the non-oxide ceramics. From the viewpoints of further enhancing the adhesive strength between the non-oxide ceramics and the oxide layer and enhancing the durability of the effect, preferably, the total concentration of the oxidizing gas contained in the atmosphere at the time of heating, particulary the total concentration of oxygen and steam, is brought to not more than 0.1 mmol/m³, particularly not more than 0.01 mmol/m³.

The oxidizing gas refers to gas having a capability of oxidizing non-oxide ceramics, for example, oxygen gas, water vapor, carbon dioxide gas, or carbon monoxide gas. The atmosphere during heating refers to an actual atmosphere within the furnace in which the influence of gas released from the furnace wall and the non-oxide ceramics as the object ceramics during heating/heating has been added. For example, even when temperature rising/heating is carried out while allowing a high-purity inert gas to flow into the furnace, oxygen or steam is released from the furnace wall and the object ceramics in the case where degassing treatment is not previously carried out. As a result, the purity of the inert gas is lowered, and, thus, the composition of the atmosphere gas during the heating is not identical to the composition of the introduced gas. In this case, the composition of the atmosphere gas during heating can be confirmed by the analysis of gas discharged from the furnace. In the present invention, there is no need to closely control the atmosphere during a period in which, after the start of heating, the temperature of the object ceramics is not very high. However, at least the atmosphere in a heating process wherein the temperature of the object ceramic shaped article is brought to 100°C or above, more preferably 200°C or above, should be controlled so that the total concentration of the oxidizing gas, particularly the total concentration of oxygen molecules and water molecules, falls within the above-defined range.

In the present invention, the non-oxide ceramics (object ceramics) as a material for the shaped article is not particularly limited so far as the non-oxide ceramics is a nitride or carbide of a metal or semi-metal, of which the melting point or decomposition temperature is equal to or above the oxidation start temperature, and conventional nitrides or carbides may be used. Specific examples of non-oxide ceramics suitable for use in the present invention include nitride ceramics such as aluminum nitride, silicon nitride, and boron nitride, and carbide ceramics such as silicon carbide, titanium carbide, and zirconium carbide. Among them, aluminum nitride and silicon nitride are suitable because of their high coefficient of thermal conductivity. Further, there is no particular limitation on the shape, size and the like. Examples of shapes include plates (including, for example, plates having throughholes or subjected to machining), tubes, rods, blocks, and, further, various deformed shapes. The non-oxide ceramic shaped article (object ceramic shaped article) used in the present invention may be crystalline non-oxide ceramics such as monocrystalline or polycrystalline non-oxide ceramics, amorphous non-oxide ceramics or non-oxide ceramics comprising a crystal phase and an amorphous phase as a mixture, and, further, sintered body produced by adding a sintering aid and optionally other additives to non-oxide ceramic powder and sintering the mixture. From the viewpoints of low cost and easy availability, the object ceramic shaped article is preferably an aluminum nitride or silicon nitride sintered body which has been formed into a predetermined shape.

For example, when the non-oxide ceramic shaped article is an aluminum nitride sintered body, the aluminum nitride sintered body used may be suitably produced by adding at least one additive selected from the group consisting of yttria, calcia, calcium nitrate, and barium carbonate to aluminum nitride powder, molding the mixture into a predetermined shape by a conventional method, and then sintering the shaped article, or by further fabricating the sintered body. On the other hand, when the non-oxide ceramic shaped article is a silicon nitride sintered body, the silicon nitride sintered body used may be suitably produced by adding at least one additive selected from the group consisting of magnesium oxide, chromic oxide, alumina, yttria, zirconia, aluminum nitride, silicon carbide, boron, and boron nitride to the silicon nitride powder, molding the mixture into a predetermined shape by a conventional method, and sintering the shaped article, or by further fabricating the sintered body.

In the present invention, before heating, the object ceramic shaped article may also be subjected to pretreatment such as roughening or polishing of the surface. For example, the roughening treatment includes etching with an aqueous alkaline solution and sandblasting. The polishing treatment includes polishing with abrasive grains and polishing by electrolytic in-process dressing grinding. A method may also be adopted in which a material, which serves as a sintering aid for an oxide (for example, aluminum oxide or silicon oxide) for constituting the oxide layer to be formed, or its precursor is previously adhered onto the surface of the object ceramic shaped article. Such materials include SiO₂, MgO, CaO, B₂O₃, and Li₂O.

In the heating step, the object ceramic shaped article is heated, by any method without particular limitation, to a temperature at or above a temperature, which is 300°C below the oxidation start temperature of the non-oxide ceramics, in an atmosphere having an oxidizing gas content of not more than 0.5 mmol in terms of total number of moles of the oxidizing gas per m³ of the inside of the furnace. However, when degassing treatment is not previously carried out, oxygen or water vapor is released from the furnace wall and the object ceramic shaped article during temperature rising by heating even in the case where, as described above, the atmosphere within the furnace is replaced by high-purity inert gas. Therefore, in general, the above requirement cannot be satisfied. A suitable method for overcoming this drawback is that, after the degassing treatment, the atmosphere in the furnace is sufficiently replaced by a high-purity inert gas having a purity of not less than 99.999%, more preferably not less than 99.9999%, most preferably not less than 99.99995%, followed by heating under the flow of the inert gas, or that the pressure within the furnace during heating is always maintained at not more than 100 Pa, preferably not more than 40 Pa, most preferably not more than 20 Pa. The degassing treatment may be carried out by any method without particular limitation so far as gas adsorbed onto the surface or gas absorbed within the ceramics can be desorbed. A suitable method is to conduct degassing at a temperature in the range of room temperature to 100°C under reduced pressure until the desorption of the gas is completed. The degree of reduced pressure (pressure within the furnace) in the degassing treatment is not particularly limited, but is preferably not more than 100 Pa, particularly not more than 20 Pa, most preferably not more than 1 Pa. The degassing and the inert gas replacement are preferably carried out a plurality of times.

In the production process according to the present invention, it is important that, until the start of the oxidation of the object ceramics, the oxidizing gas or the oxygen derived from the oxidizing gas is not substantially dispersed in the object ceramic shaped article. To this end, until the temperature reaches the oxidation reaction start temperature, heating is preferably carried out in the above atmosphere. However, when the object ceramics is heated to a temperature at or above a temperature which is 300°C below the oxidation start temperature of the object ceramics, even with the introduction of an oxygen gas into the system (furnace), the regulation of the heating up rate (even when the heating up rate is, for example, in the range of 10 to 80°C/min., preferably 30 to 50°C/min., which is practically controllable) can realize heating of the object ceramic shaped article to the oxidation reaction start temperature without causing disadvantageous oxygen diffusion and without significant damage to the object ceramic shaped article. When the highest temperature in heating under such conditions that oxygen is not dissolved in a solid solution form, is below a temperature which is 300°C below the oxidation start temperature of the object ceramics, in order to raise the temperature of the object ceramics to the oxidation start temperature without causing diffusion of oxygen and the like which adverse affect oxide layer formation, the heating up rate should be increased. The heating at the high heating up rate disadvantageously involves deformation or the occurrence of cracks depending upon the size or shape of the object ceramic shaped article. Preferably, the object ceramics is heated to a temperature at or above a temperature which is 100°C below the oxidation start temperature of the object ceramics, particularly to a temperature at or above the oxidation start temperature of the object ceramics in the above atmosphere, although this also varies depending upon the performance of the furnace used and the size or shape of the object ceramic shaped article.

Here the oxidation start temperature refers to a temperature at which, when the obj ect ceramics is heated under an oxidizing gas atmosphere, an oxidation reaction takes place rapidly. In the present invention, the oxidation start temperature refers to a temperature at which, when the object ceramics is heated at a heating up rate of 1 to 100°C/min., preferably 75°C/min., under the reaction pressure in an oxygen atmosphere, the oxidation reaction rate of the object ceramics changes critically. The oxidation start temperature can easily be specified as the temperature at which, in the results of thermogravimetric analysis in heating the object ceramics under the above conditions, a rapid weight change starts, or as the temperature at which, in the results of differential thermal analysis, rapid heat generation starts. For example, the oxidation start temperature of aluminum nitride under the atmospheric pressure is 1100°C, as shown in Fig. 1.

In the production process of the present invention, subsequent to the heating step, the object ceramic shaped article heated in the heating step is brought into contact with an oxygen gas, and, then, the object ceramics is held at a temperature above the oxidation start temperature of the object ceramics to oxidize the surface of the object ceramic shaped article and thus to form an oxide layer (hereinafter referred to also as "oxidation step").

In this case, in order to avoid the occurrence of defects such as cells or voids in the boundary of the oxide layer and the non-oxide ceramic layer, particularly preferably, in addition to closely control the atmosphere during heating, in bringing the obj ect ceramic shaped article into contact with the oxidizing gas, the atmosphere is closely controlled in a predetermined period after the start of the contact (hereinafter referred to also as "initial contact period").

That is, the heating step and the oxidization step in the production process according to the present invention includes the steps of:
(I) introducing the non-oxide ceramic shaped article into a furnace, then discharging an oxidizing substance adsorbed or sorbed to the non-oxide ceramic shaped article and to a furnace material outside of the furnace, so as to regulate an oxidizing gas content in the atmosphere within the furnace to be not more than 0.5 mmol in terms of total number of moles of the oxidizing gas per m³ of the inside of the furnace; and
(II) heating the non-oxide ceramic shaped article to a temperature at or above a temperature, which is 300°C below the oxidation start temperature of the non-oxide ceramics, while maintaining the atmosphere in the furnace having an oxidizing gas content of not more than 0.5 mmol in terms of total number of moles of the oxidizing gas per m³ of the inside of the furnace; and
(III) bringing the non-oxide ceramic shaped article heated in the step (II) and an oxidizing gas into contact with each other and then holding the non-oxide ceramic shaped article at a temperature above the oxidation start temperature of the non-oxide ceramics to form an oxide layer on the surface of the non-oxide ceramic shaped article, and
(IV) when bringing the non-oxide ceramic shaped article into contact with the oxidizing gas in the step (III), until at least 2 min. elapses after the arrival of the temperature of the non-oxide ceramic shaped article at or above the oxidation start temperature thereof, the pressure or partial pressure of the oxidizing gas is maintained at not more than 50 kPa. More specifically, the pressure or partial pressure of the oxidizing gas should be maintained at not more than 50 kPa in a period until two min. or longer elapses after the start of contact when the contact is started at a temperature at or above the oxidation start temperature, or a period of the sum of a period until the temperature reaches the oxidation start temperature after the start of the contact, and a period until two min. or longer elapses after the temperature reaches the oxidation start temperature when the contact is started at a temperature below the oxidation start temperature.

After the expiration of the contact start period, the occurrence of any defect in the interface can be significantly suppressed even when the pressure or partial pressure of the oxidizing gas is increased to a value exceeding the above upper limit value. This is probably because the structure of the boundary is determined in an early stage of the oxidation reaction and, after the formation of a thin oxide film in a good state, the good interfacial state is also maintained in the subsequent oxide film growth stage.

When the pressure or partial pressure of the oxidizing gas in the initial contact period exceeds the upper limit of the above-defined range, although a better oxide layer free from specific cracks than the oxide layer formed by the conventional oxidation process, defects sometimes occur in the boundary of the oxide layer and the non-oxide ceramics and, consequently, the adhesive strength between the oxide layer and the non-oxide ceramics is sometimes lowered. In this case, the oxide layer is sometimes separated, for example, in a heat cycle test. From the viewpoint of attaining the effect of preventing the occurrence of defects in the boundary, preferably, the pressure or partial pressure of the oxidizing gas is not more than 40 kPa, particularly preferably not more than 30 kPa, in a period until at least 2 min. elapses after the arrival of the temperature of the non-oxide ceramic shaped article at or above the oxidation start temperature of the non-oxide ceramics after the start of the contact between the object ceramics and the oxidizing gas, and is brought to not more than 55 kPa, particularly preferably not more than 50 kPa, in a period until at least 3 min. elapses after the temperature reaches a temperature at or above the oxidation start temperature.

In the oxidation step, when the object ceramic shaped article heated to a predetermined temperature is brought into contact with the oxidizing gas, the following method may be adopted. The temperature of the object ceramic shaped article is monitored. After it is confirmed that the temperature of the object ceramics has reached a predetermined temperature, an oxidizing gas having a predetermined pressure, or a mixed gas comprising an oxidizing gas diluted with an inert gas and having a predetermined partial pressure of the oxidizing gas is introduced into the furnace. The object ceramic shaped article is held at a temperature at or above the oxidation start temperature in the presence of the gas for a predetermined period of time or longer, and, if necessary, the pressure or partial pressure of the oxidizing gas is increased. In this case, the pressure or partial pressure of the oxidizing gas in the initial contact period may be either constant or varied. From the viewpoint of the effect of preventing the occurrence of defects in the boundary, preferably, the pressure or partial pressure of the oxidizing gas is increased from 0 Pa either stepwise or continuously with the elapse of time in such a range that does not exceed the upper limit value. When the untreated ceramic shaped article has a complicated shape and the oxidation of the surface of the complicated shape is contemplated, preferably, the pressure of the oxidizing gas or an oxidizing gas-containing gas (hereinafter referred to also as "gas for oxidation") is fluctuated from the viewpoint of improving the contact of the untreated ceramic shaped article with the oxidizing gas.

In the heating step, in the heating under the flow of an inert gas, when the introduction of the inert gas is stopped followed by the introduction of the oxidizing gas, the atmosphere within the furnace is not immediately replaced by the oxidizing gas. Therefore, the partial pressure of the oxidizing gas in the initial contact period can be regulated by regulating the flow rate of the oxidizing gas while taking into consideration the space of the furnace, into which the gas is introduced, and the gas flow state. In this case, however, care should be taken to the introduction of the oxidizing gas, because the diffusion of the gas is influenced by the gas introduction site and the structure within the furnace, often resulting in locally increased partial pressure of the oxidizing gas.

A good oxide layer can be formed when the temperature at which the contact between the object ceramic shaped article and the oxidizing gas is started, is a temperature at or above a temperature which is 300°C below the oxidation start temperature of the object ceramics. In order to more reliably form a good oxide layer, preferably, the temperature at which the contact between the object ceramics and the oxidizing gas is started, is a temperature at or above a temperature which is 100°C below the oxidation start temperature of the object ceramics, particularly preferably a temperature at or above the oxidation start temperature of the object ceramics.

The oxidizing gas or oxidizing gas-containing gas (gas for oxidation) used for the oxidation of the object ceramic shaped article in the oxidation step may be the above-described oxidizing gas without particular limitation. From the viewpoint of causing no significant defect in the oxide layer, the use of a gas having a dew point of -50°C or below is preferred, and the use of a gas having a dew point of -70°C or below is most preferred. For example, ultrahigh pure oxygen gas, ultrahigh pure carbon monoxide gas, ultrahigh pure carbon dioxide gas, a mixed gas composed of these gases, a mixed gas prepared by diluting the ultrahigh pure gas with an ultrahigh pure inert gas, and dehydrated air are preferred.

The concentration of the oxidizing gas in the gas for oxidation affects the oxide layer formation rate. In general, the higher the oxygen concentration, the higher the oxide layer formation rate. Therefore, from the viewpoint of efficiency, after the expiration of the initial contact period, the use of a gas having an oxygen concentration of not less than 50% by volume as the gas for oxidation is preferred, and the use of a gas having an oxygen concentration of not less than 99% by volume is particularly preferred.

In the oxidation step, the object ceramics shaped article should be contacted with the gas for oxidation at a temperature at or above the oxidation start temperature. When the oxidation temperature is excessively high, the energy cost is high and, at the same time, the regulation of the thickness of the oxide layer is difficult. Therefore, the oxidation temperature is preferably at or below a temperature which is 500°C above the oxidation start temperature, particularly preferably at or below a temperature which is 300°C above the oxidation start temperature. The oxidation time may be properly determined by taking into consideration the concentration of oxygen in the gas for oxidation, the oxidation temperature, and the thickness of the oxide layer to be formed. For example, in order to provide aluminum nitride having a 1000 to 3000 nm-thick α-alumina layer, a temperature above the oxidation start temperature may be generally held for 0.5 to 5 hr. The oxide layer formed in the oxidation step is formed of an oxide of a metal or semi-metal as a constituent of the non-oxide ceramics as the object ceramics. Nitrogen or carbon may be dissolved in the oxide layer to form a solid solution depending upon the type of the object ceramics.

After the completion of the oxidation treatment, the oxidized non-oxide ceramic shaped article may be cooled and taken out of the furnace. At the time of cooling, preferably, the oxidized non-oxide ceramic shaped article is gradually cooled so as to avoid damage to the non-oxide ceramic shaped article and the oxide layer.

The non-oxide ceramic shaped article having an oxide layer on its surface produced by the oxidation step according to the present invention is also characterized in that the above-described specific cracks are substantially absent, that is, "when branched cracks are divided into crack units located between adjacent branch points and crack units extending from the end to the nearest branch point, a branched crack having a crack unit meeting a "w" value of not less than 20 nm, an "1" value of not less than 500 nm and a "w/l" value of not less than 0.02, wherein "1" (nm) represents the length of each crack unit, and "w" (nm) represents the maximum width of each crack unit", is substantially absent in the oxide layer formed on the surface of the non-oxide ceramic shaped article.

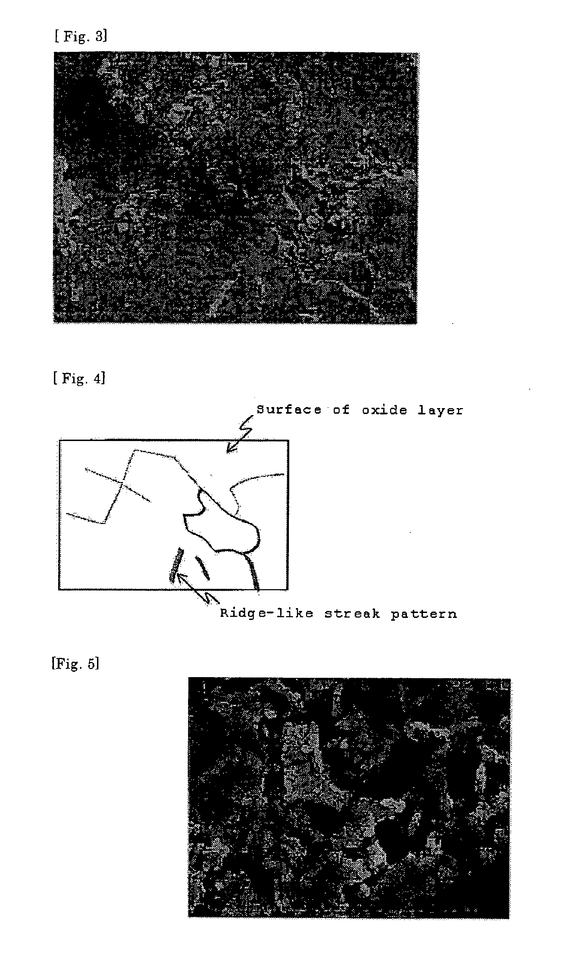

The above specific cracks will be further described in more detail with reference to the accompanying drawings. For example, when the branched crack 1 has a shape as shown in Fig. 2, 2a to 2e represent respective crack units. In the determination of "1", "w" and "w/l" for each crack unit, when even one crack unit simultaneously meets a "w" value of not less than 20 nm, an "1" value of not less than 500 nm and a "w/l" value of not less than 0.02 preferably not less than 0.01, the branched crack 1 is regarded as a specific crack. When none of the crack units meet a "w/l" value of not less than 0.02, preferably not less than 0.01, the branched crack 1 is not a specific crack. The absence of the specific crack can be confirmed by the observation of the surface of the oxide layer by a scanning electron microscope (SEM). Substantial freedom from a specific crack means that, for one sample, the number of specific cracks found in the observation of arbitrarily selected 10 visual fields (visual fields having a radius of 30000 nm), preferably 50 visual fields, is not more than 0.2, preferably not more than 0.1, most preferably not more than 0.05, on average per visual field. Concaves and convexes are often formed on the surface of the oxide film as a result of a reflection of the shape of the underlying non-oxide ceramics, or depending upon the way of growth of the oxide film. The concaves observed in this case are not cracks, and the crack referred to in the present invention refers to a crack by which at least the surface layer part in the oxide layer is discontinuously broken.

When the heating step and the oxidation steps are carried out in such a manner that satisfies the above requirements (I) to (IV), the formed oxide layer is characterized in that, in addition to the substantial freedom from specific cracks, voids or cells are not substantially present in the oxide layer around the boundary of the non-oxide ceramic layer and the oxide layer (this region being hereinafter referred to also as "void-free region") , and the adhesive strength between the non-oxide ceramic layer and the oxide layer is very high. The void-free region is a layer region spread in a certain thickness from the boundary over the whole area of the oxide layer. The thickness of the void-free region is 20 to 100 nm when the thickness of the whole oxide layer is 0.1 to 100 µm. Substantial freedom from voids or cells means that the void ratio in the void-free region (the proportion of the volume of voids to the whole void-free region) is not more than 5%, preferably not more than 3%, particularly preferably not more than 1%. A number of voids having a diameter of about 50 to 100 nm are observed in the oxide layer region other than the void-free region, particularly the region except for the area around the surface layer, whereas, in the void-free region, such voids are hardly observed and, even when voids are present, most of the voids have a diameter of not more than 5 nm, preferably not more than 1 nm. Regarding the surface layer part in the oxide layer, there is a tendency that, when the thickness of the oxide layer is increased, the voids are reduced and the diameter is increased.

The presence of the void-free region can be confirmed by the observation of the cross section of the sample by a transmission electron microscope (TEM). In this case, voids are observed in the TEM photograph as a white- or light gray-color distorted elliptical (in some case, seen like a polygonal shape) pattern. When the thickness of the observed sample is uneven, the determination of the voids is difficult. Therefore, the thickness of the sample for observation by TEM should be even and in the range of 50 to 100 nm. The above sample can be prepared as follows. Specifically, in a focused ion beam (FIB) system widely used in the preparation of samples for TEM observation, the sample is polished by accelerated gallium ion. In this case, the periphery is polished so that, as viewed from the sample surface, a region having a breadth of 10 to 20 µm and a length of 50 to 100 nm is left. The polishing region can be confirmed by a scanning ion microscope (SIM) which, upon the application of gallium ion, detects secondary electrons generated from the sample to obtain an image. In general, SIM is attached to an FIB apparatus, and the polishing region can be accurately confirmed by this SIM observation and, thus, a sample for TEM observation having an even thickness in the range of 50 to 100 nm can be prepared.

When the non-oxide ceramic shaped article is a non-oxide ceramic sintered body, it is known that, in the course of producing a sinter, crystals of a sintering aid are sometimes precipitated on the surface of the sinter. When this sinter is oxidized in the production process of the present invention, an oxidation reaction proceeds also in the grain boundary between the crystal of the sintering aid and the non-oxide ceramic sinter and, consequently, the non-oxide ceramic in its part just under the precipitated sintering aid crystal is also oxidized. Furthermore, the boundary of the oxide layer in its part and the non-oxide ceramic sintered body is free from defects such as cells or voids. This fact suggests that, even when a small amount of foreign matter is present on the surface of the non-oxide ceramic, the foreign matter is embraced in the oxide layer and, consequently, the product is less likely to be adversely influenced by the foreign matter. The process according to the present invention is also valuable in this point.

In the process according to the present invention, subsequent to the oxidation step, a metal layer is formed on the surface of the oxide layer in the non-oxide ceramic shaped article having an oxide layer on its surface obtained in the oxidation step (metallization step). The metallization can be carried out by any conventional metallization method, without particular limitation, for example, a thin-film formation method, a thick-film formation method, a DBC method, and an active metal brazing method. In the metallization, the conventional metallization methods as such may be applied except that the non-oxide ceramic shaped article subjected to oxidization treatment by the oxidation step in the process according to the present invention is used as the shaped article. These metallization methods will be described.

The thin-film formation method is a method in which a metallic thin film layer is formed on the surface of the substrate by vapor phase metallization such as vapor deposition, sputtering, and CVD, wet metallization such as electroless plating and electroplating, and a combination of these methods. In the vapor phase metallization, metallization of any metal is possible. When the metal layer has a multilayer structure, the metal, which comes into contact with the ceramic shaped article (the metal as the lowermost layer in the multilayered metal layer), is preferably at least one metal selected from the group consisting of Ti and Zr (group 4 (group IVa) metals) and Cr, Mo, and W (group 6 (group VIa) metals) that are highly reactive and have high adhesion. On the other hand, the metal constituting the upper layer is preferably Cu, Au, Ag, or other metals that have high electric conductivity and have malleability high enough to absorb a thermal expansion coefficient difference. Further, a layer of other metal such as Pt or Ni may be provided between the lowermost layer and the upper layer. When the layer thickness is unsatisfactory, the thickness may be increased by plating. Some non-oxide ceramics are unstable against water or a liquid chemical such as an aqueous alkali solution and thus are often subjected to restrictions when plating is applied. On the other hand, in the metallized shaped article according to the present invention, since the surface of the non-oxide ceramic shaped article is covered with a good oxide layer, plating can be applied without any particular restriction.

The thick-film formation method is a method in which, for example, a conductor pattern (a wiring circuit) or a resistor is printed using a metal paste on a ceramic shaped article as a base material, for example, by screen printing and the printing is then baked to form an electronic circuit. The metal paste is a paste prepared by adding, to a metal powder, optionally a vitreous, oxide (chemical bond) or mixed (mixed bond) glass frit and a ceramic powder for regulating the coefficient of thermal expansion and the like, further adding an organic solvent or the like, and kneading the mixture to prepare a paste. In the present invention, conventional metal pastes can be used without particular limitation. Further, the so-called "post firing method," which is somewhat different from the thick-film formation method, may also be adopted as the metallization step in the present invention, in which a metal paste is filled into throughholes (having, on the surface thereof, an oxide layer formed by the oxidation step) provided in a substrate to form via holes. In the thick-film formation method and post firing method for the non-oxide ceramic shaped article, it is common practice to use a specialty metal paste. In the metallization step in the present invention, high adhesion can be realized even when a metal paste for oxide ceramics such as alumina is used. Also when the thick film formation method is used, this method may be used in combination with a plating method. In the metallization of the conventional non-oxide ceramic shaped article, when a combination of a thin film formation method other than the plating method with the plating method, or a combination of a thick film formation method with the plating method is used as the metallization method, the plating treatment (particularly electroless plating) renders the bonding strength of the metal layer lower than the bonding strength before the plating treatment. In the method according to the present invention, this problem is less likely to occur. From the viewpoint of attaining this effect, suitable methods for the metallization in the process according to the present invention include metallization methods including plating treatment, particularly a combination of a thin film formation method other than the plating method with the plating method and a combination of a thick film formation method with the plating method. Especially, a combination of a thin film formation method other than the plating method with an electroless plating method and a combination of a thick film formation method with an electroless plating method are preferable.

A DBC (direct bond copper) method is a method in which copper (a plate or film) containing a very small amount of oxygen is brought into contact with a ceramic shaped article as a base material, followed by heating in a nitrogen atmosphere to bond the copper to the ceramic shaped article. In this method, in the case of materials wettable by a liquid phase component (Cu₂O) produced upon heating, for example, oxide ceramics such as alumina, good bonding can be realized. On the other hand, in the case of non-oxide ceramics such as aluminum nitride, due to poor wettability by Cu₂O, the surface of the non-oxide ceramics should be previously subjected to oxidation treatment for rendering the surface wettable. Accordingly, it is a matter of course that the DBC method can be applied in the metallization according to the present invention, and, since the oxide layer formed by the step of oxidation in the present invention has the above-described feature, as compared with the case where the conventional method is adopted in the oxidation treatment, a bonding mechanism by the DBC method can be ideally realized. Therefore, an improvement in bonding strength and bonding durability can be achieved over the bonding strength and bonding durability attained by the conventional products.

On the other hand, the "active metal brazing method" is a method in which an active metal brazing material is printed and coated onto the surface of a ceramic shaped article as a base material to stack a metal such as Cu (copper) or Al (aluminum) on the surface of the ceramic shaped article, followed by heating in vacuum or in an inert gas for bonding. Brazing materials include Ag-Cu-Ti-base materials, Cu-Sn-Ti-base materials, Ni-Ti-base materials, and aluminum alloy materials. Among them, Ag-Cu-Ti-base materials are most commonly used. This method can be applied to most ceramics and thus can of course be effective for surface oxidized aluminum nitride substrates. In particular, since the oxide layer formed in the step of oxidation in the present invention has the above-described feature, the contemplated effect can be more ideally attained as compared with the case where the conventional method is adopted, and, thus, an improvement in bonding strength and bonding durability can be achieved over the bonding strength and bonding durability attained by the conventional products.

In the process according to the present invention, after the step of metallization, if necessary, post treatments such as various steps involved in etching or lithography may also be carried out.

Next, the Peltier element according to the present invention will be described.
The Peltier element according to the present invention has the same structure as the conventional Peltier element, except that a specific "non-oxide ceramic substrate having an oxide layer on its surface" is used as a pair of substrates for holding a thermoelectric material member between them. The structure of the Peltier element according to the present invention will be described in conjunction with the accompanying drawings.

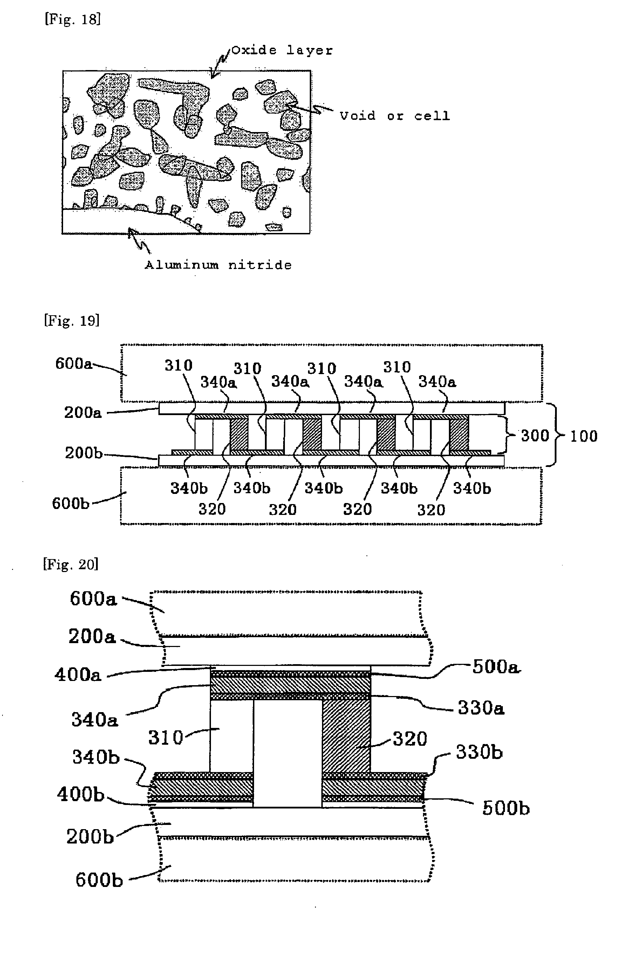

Fig. 19 is a cross-sectional view of a typical Peltier element according to the present invention. Fig. 20 is a partially enlarge view of the Peltier element shown in Fig. 19. As shown in Fig. 19, a Peltier element 100 includes a first substrate 200a and a second substrate 200b that are disposed opposite to each other. In these substrates, an oxide layer has been formed on the surface by a specific method which will be described later. This oxide layer is substantially free from specific cracks on its surface. In the Peltier element 100, a thermoelelctric material member 300 is disposed between the first substrate 200a and the second substrate 200b. The thermoelectric material member 300 includes alternately arranged P-type thermoelectric materials 310 and N-type thermoelectric materials 320. As shown in Figs. 19 and 20, each thermoelectric material {P-type thermoelectric material (or N-type thermoelectric material)} is electrically connected to a thermoelectric material {N-type thermoelectric material (or P-type thermoelectric material) } adjacent to one side of the thermoelectric material by bonding the upper surface of the thermoelectric materials and the upper surface of the other thermoelectric material to an electrode 340a through a solder layer 330a, and, at the same time, the other side of the thermoelectric material is electrically connected to another thermoelectric material {N-type thermoelectric material (or P-type thermoelectric material)} adjacent to the other side of the thermoelectric material by bonding the lower surface of the thermoelectric materials and the lower surface of the other thermoelectric material to an electrode 340b through a solder layer 330b. Further, as shown in Fig. 20, metal layers 400a and 400b constituting a conductor circuit pattern are provided on the inner side of the first substrate 200a and the second substrate 200b. The metal layers 400a and 400b are bonded respectively to the electrodes 340a and 340b in the thermoelectric material member 300 respectively through second solder layers 500a and 500b. In the Peltier element 100, a first heat transfer material 600a such as a heat source is bonded to the outer side of the first substrate 200a, and a second heat transfer material 600b such as a radiator is bonded to the outer side of the second substrate 200b. Alternatively, a structure may also be adopted in which the metal layers 400a and 400b functions also as the metal electrodes 340a and 340b (not shown).

Any P-type thermoelectric material and N-type thermoelectric material commonly used in the conventional Peltier element such as Bi-Te materials may be used as the P-type thermoelectric material and N-type thermoelectric material without particular limitation in the Peltier element according to the present invention. Particularly suitable P-type thermoelectric materials include (Bi_{0.25}Sb_{0.75})₂Te₃. Particularly suitable N-type thermoelectric materials include Bi₂ (Te_{0.95}Se_{0.05})₃. Metals having low electric resistance such as Cu and Al are suitable as the material for the metal electrodes 340a and 340b. Conventional solder materials such as Pb-Sn solder, Au-Sn solder, Ag-Sn solder, Sn-Bi solder, and Sn-In solder can be used without particular limitation as the solder in the formation of the solder layers 330a, 330b, 500a, 500b. The use of Pb-Sn solder and Au-Sn solder is suitable from the viewpoints of low melting point and high bonding strength.

The most characteristic feature of the Peltier element according to the present invention is that the above-described plate-shaped "non-oxide ceramic shaped article having an oxide layer on its surface" (surface oxidized shaped article) is used as the substrates 200a and 200b. The use of the substrate (surface oxidized substrate) is advantageous in that the adhesion between the substrate and the thermoelectric material member in the Peltier element is high and the adhesion durability is also excellent. At the same time, the use of the substrate (surface oxidized substrate) is also advantageous in that, even when a plating method is applied in the production process of the Peltier element, particularly in the step of metallization, the substrate is not deteriorated.

In the Peltier element according to the present invention, a conductor pattern formed of the metal layers 400a and 400b as shown in Fig. 20 is provided on the surface of the surface oxidized substrate, and the surface oxidized substrate is used as the substrate (200a and 200b) for a Peltier element.

Conventional metallization methods such as a thin film formation method, a thick film formation method, and a DBC method, may be adopted without particular limitation in the formation of the conductor pattern. When the non-oxide ceramics is aluminum nitride, however, from the viewpoint of forming a thick conductor pattern formed of a low-resistance metal in a simple and low-cost manner, a method is suitably adopted in which, after the formation of a pattern formed of a metal layer (a first metal layer) composed of copper or composed mainly of copper by a thick film formation method, a layer (a second metal layer) formed of a metal different from the metal constituting the metal layer is formed on the pattern by the plating method. A thick film printing method using a copper-based paste for a thick film can be applied in the formation of the pattern formed of the first metal layer by the thick film formation method. The thickness of the first metal layer is generally 5 to 500 µm, preferably 10 to 100 µm. The second metal layer provided on the pattern functions a barrier layer for preventing the diffusion of the solder metal into the first metal layer or as an adhesive layer for improving adhesion to the solder metal. The second metal layer is generally a metal layer formed of at least one metal selected from the group consisting of Ni (including Ni-P composite and Ni-B composite), Ni-Au alloys and Pt. The thickness of the second metal layer is generally 0.5 to 50 µm, preferably 1 to 20 µm. Electroless plating is suitable in the method for the second metal layer formation.

The process for producing the Peltier element according to the present invention using the "ceramic substrate having a conductor pattern on its surface" produced by the above production process is same as the conventional process. For example, a production process comprising the following steps A, B and C can be adopted.

Step A: a step of providing a thermoelectric material member comprising alternately arranged P-type thermoelectric materials and N-type thermoelectric materials, wherein the top face of each of the thermoelectric materials is connected electrically to the top face of the thermoelectric material adjacent to one side thereof through an electrode, and, at the same time, the bottom face of each of the thermoelectric materials is connected electrically to the bottom face of the thermoelectric material adjacent to the other side thereof through an electrode,
step B: a step of providing a pair of ceramic substrates each having a conductor pattern on its surface, the conductor pattern in each of the ceramic substrates being provided so that, when the thermoelectric material member is held between the ceramic substrates, the conductor pattern is connected electrically to the electrode in the thermoelectric material member, and
step C: a step of disposing the thermoelectric material member between the pair of ceramic substrates and soldering the electrodes in the thermoelectric material member to the conductor pattern in each of the ceramic substrates.

In step A, a thermoelectric material member 300 shown in Fig. 19 is provided. For example, P-type thermoelectric materials 310 and N-type thermoelectric materials 320 each having a metal electrode (not shown) on their upper and lower surfaces are alternately arranged, and electrodes 340a and 340b are disposed as shown in Fig. 19. The electrode part in each thermoelectric material is soldered to the electrodes 340a and 340b. In step B, substrates 200a and 200b shown in Fig. 19 are provided by the above-described process. Further, in step C, a thermoelectric material member 300 is soldered and fixed between a pair of the substrates 200a and 200b. In this step, accurate soldering can be realized by previously forming solder layers (500a and 500b) on the conductor pattern in each substrate and conducting reflow soldering.

As is apparent from the results of evaluation of various items for the "non-oxide ceramic substrates having an oxide layer on the surface thereof" produced by the following Examples, the Peliter element according to the present invention produced by the above process has excellent features that (i) the bonding strength between the substrate and the thermoelectric element is high, (ii) the durability of the bonding strength between the substrate and the thermoelectric element is high, and (iii) even when a plating method is applied in the metallization, damage to the substrate does not occur and, further, the adhesive strength of the metallized layer is not deteriorated.

The present invention will be described in more detail with reference to the following Examples. However, it should be noted that the present invention is not limited to these Examples.

Examples 1 and 2 (Example of new oxidation process in which degassing treatment is carried out and the partial pressure of oxygen in initial contact period falls within suitable range)
1. Production of "non-oxide ceramic substrate having an oxide layer on its surface"
   An aluminum nitride substrate in a plate form having a size of 50.8 mm in length, 50.8 mm in width, and 0.635 mm in thickness and a surface roughness Ra of not more than 0.05 µm (SH 15, manufactured by TOKUYAMA Corp.) was introduced into a high-temperature atmosphere furnace comprising a mulite ceramic having an inner diameter of 75 mm and a length of 1100 mm as a furnace tube (SUPER BURN rebuilt type, manufactured by MOTOYAMA Co., Ltd.). The inside of the furnace was evacuated by a rotary vacuum pump to not more than 50 Pa. Thereafter, the atmosphere in the evacuated furnace was replaced by nitrogen gas (purity 99.99995%, dew point -80°C) by pressure increase, and the furnace was heated to 1200°C (heating up rate: 3.3°C/min.) under nitrogen flow at a flow rate of 2 (1/min.). After the temperature around the substrate was confirmed to reach 1200°C, the nitrogen gas flow was stopped. Next, oxygen gas (purity 99.999%, dew point -80°C) was flowed at a flow rate of 1 (l/min.), and this condition was held for one hr to oxidize the surface of the aluminum nitride substrate. After the completion of oxidation, the substrate was cooled to room temperature (cooling down rate: 3.3°C/min.) to provide a surface oxidized aluminum nitride substrate (sample 1) (Example 1).

In the above production process, at the same time as the start of the heating, gas discharged from the furnace was introduced into a gas chromatograph (personal gas chromatograph GC-8A, manufactured by Shimadzu Seisakusho Ltd., detector: TCD, column: SUS 3 φ x 2 m, filler: molecular sieve 13 X-S 60/80, manufactured by GL Sciences Inc.) and was analyzed for components over time. As a result, during heating, any component other than nitrogen was not detected in any temperature region. When 10 min. elapsed from the start of flow of oxygen into the furnace, the waste gas was analyzed. As a result, in addition to oxygen as the flow gas, nitrogen considered to have been produced in the reaction process was detected. The height of the nitrogen peak became the highest value after the start of oxygen flow and reduced with the elapse of the temperature holding time. The partial pressure of oxygen gas in a portion around the sample 2 min. and 3 min. after the start of introduction of oxygen was determined from a nitrogen peak reduction pattern and a separately prepared calibration curve. As a result, the partial pressure 2 min. after the start of introduction of oxygen and the partial pressure 3 min. after the start of introduction of oxygen were 28 kPa and 47 kPa, respectively.

A surface oxidized aluminum nitride substrate (sample 2) was produced in the same manner as described above, except that the holding time in the oxidation step was changed to 10 hr (Example 2).

2. Evaluation of substrate
A part of samples 1 and 2 produced in the above production Examples was provided as an analytical sample, and the oxide layer in these samples was subjected to XRD analysis, surface observation by SEM, cross-sectional observation by TEM, and an alkali resistance test. Specific methods for these analyses and the results are shown below.

(1) Identification of reaction product by XRD
The sample was subjected to XRD measurement with an X-ray diffraction apparatus (RINT-1200, manufactured by Rigaku Industrial Corporation). As a result, it was confirmed from the diffraction pattern that the oxide layer in the sample was formed of α-alumina. The measurement was carried out under conditions of incident X-ray Cu-Kα radiation, tube voltage 40kV, tube current 40 mA, receiving slit 0.15 mm, and monochrome receiving slit 0.60 mm.

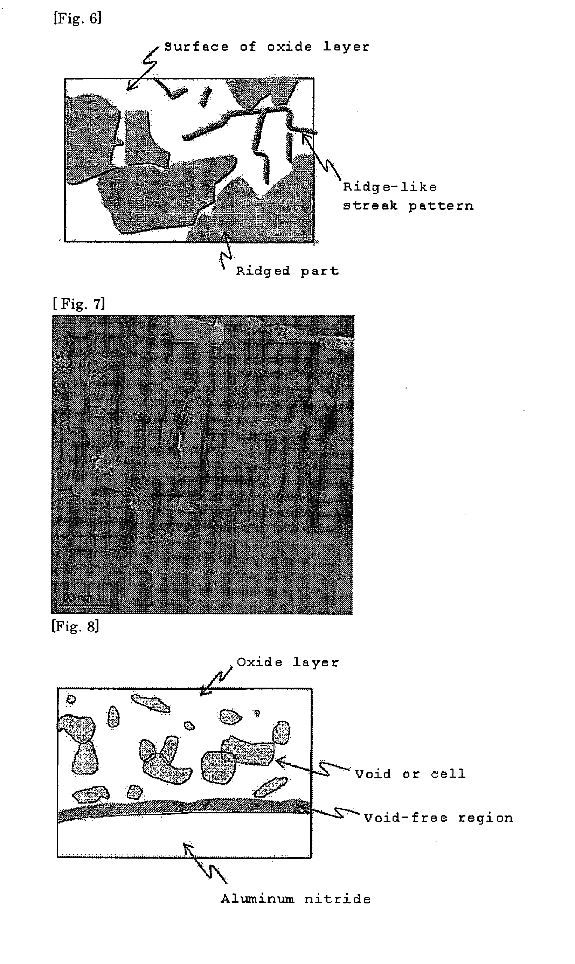

(2) Observation of surface by SEM
The sample was cut with a diamond cutter into a size of 5 mm x 5 mm, and the cut sample was fixed onto a sample table for observation with a carbon tape so that the oxidized surface faced upward. This sample was then coated with Pt by an ion sputtering apparatus (magnetron sputtering apparatus JUC-5000, manufactured by Japan Electric Optical Laboratory) , and the sample surface was observed by FE-SEM (Field Emission-Scanning Electron Microscope JSM-6400, manufactured by Japan Electric Optical Laboratory). The observation was carried out under conditions of acceleration voltage 15 kV, probe current 5 x 10⁻¹¹ A, emission current 8 µA, and magnification 10,000 times. In this case, 50 visual fields were arbitrarily observed, and these sites were photographed. Typical photographs of samples 1 and 2 are shown in Figs. 3 and 5, respectively, and illustrations thereof are shown in Figs. 4 and 6, respectively. As shown in Figs. 3 and 5, although a ridge-like streak pattern was observed on the surface of the oxide layer, any crack was not observed (this was true of the remaining visual fields). Further, the thickness of the oxide layer was determined by observation by SEM of a broken surface of the sample and was found to be 900 nm on average for sample 1 and 3600 nm for sample 2.

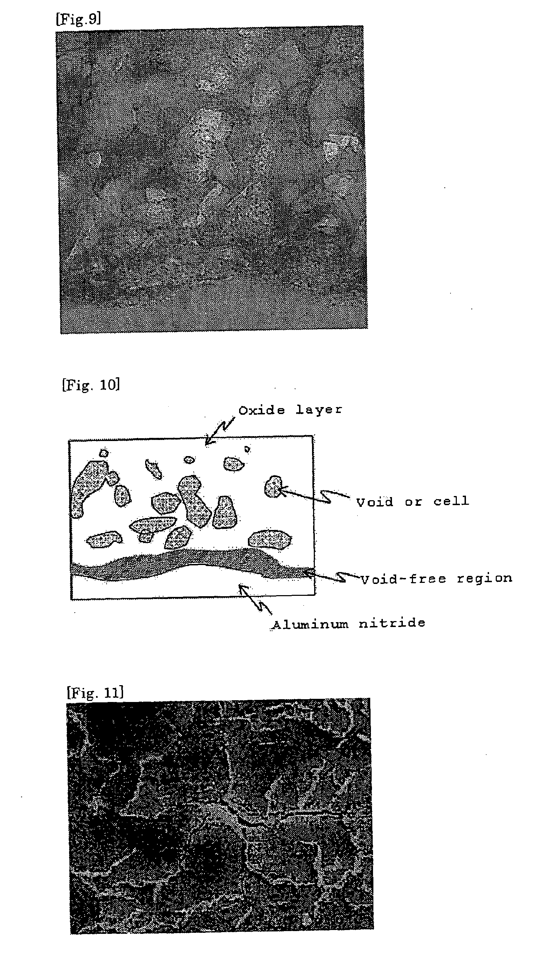

(3) Observation of cross-section of oxide layer by TEM
The cross-section of the oxide layer was observed by a field emission-type transmission electron microscope (TECNAI F20) manufactured by FEI under conditions of acceleration voltage 200 kV, spot size 1, gun lens 1, and objective aperture 100 µm. A part around the boundary of the oxide layer and the nitride ceramics was observed at a magnification of 50000 times, and the site was photographed. Typical photographs of samples 1 and 2 are shown in Figs. 7 and 9 respectively, and illustrations thereof are shown in Figs. 8 and 10, respectively. As shown in Figs. 7 and 9, elliptical cells (or voids) were observed in the oxide layer while a "substantially cell-free region (layer)" having an average thickness of 48 nm was present in a part of the oxide layer around the boundary between the oxide layer and the underlying material. The sample was prepared by the following method.

Specifically, the sample was cut into a rectangular parallelepiped having a size of 1 mm in transverse direction and 50 µm in longitudinal direction as viewed from the sample surface with a dicing machine (DAD 320) manufactured by DISCO CORPORATION). The rectangular parallelepiped sample was processed by a focused ion beam system (SMI 2200) manufactured by SII NanoTechnology Inc. for cross-sectional observation. In all the cases, the acceleration voltage was 30 kV. The periphery of the rectangular parallelepiped sample was ground while observing the surface of the rectangular parallelepiped sample by a scanning ion microscope (SIM) until the longitudinal size of the sample, which was 50 µm before grinding, became 70 nm. The sample breadth to be ground may be any desired value and was 20 µm in this Example. The sample depth to be ground was set so that the whole oxide layer and a part of the nitride ceramics (about 1 µm) could be observed by observation of the cross-section of the sample by SIM.

(4) Alkali resistance test
Samples prepared in the same manner as in the samples 1 and 2 were covered with a fluororesin seal tape so that a part of the oxide layer was exposed (exposed area S = 3 mm x 5 mm = 15 mm² = 1.5 x 10⁻⁵ m²). The sample covered with the seal tape was immersed in a 5% aqueous solution of sodium hydroxide at 30°C for 5 hr in such a manner that the part other than the exposed part did not come into contact with the solution. The weight of the dried sample was measured before and after the soaking. The weight "W_{b}" of the dried sample corresponding to the sample 1 before the soaking was 166. 5 (mg) , and the weight "Wₐ" of the dried sample corresponding to the sample 1 after the soaking was 166.2 (mg). The "reduction in dry weight by soaking per unit area" (hereinafter referred to simply as "weight reduction") calculated based on these values was 10 (g/m²). The weight reduction of the sample corresponding to the sample 2 was 20 (g/m²). The same test was carried out as a reference experiment for an aluminum nitride substrate not subjected to surface oxidation treatment. As a result, the weight reduction was 113 (g/m²).

3. Production of metallized substrate
The samples 1 and 2 thus obtained were cleaned in acetone with an ultrasonic cleaner manufactured by Ultrasonic Engineering Co., Ltd. (transducer: MT-154P06EEA, oscillator: ME-154A601AA20) for 10 min. and was then dried in methylene chloride vapor with a steam washer LABOCLEAN LC-200 manufactured by NIKKA SEIKO CO., LTD. for 5 min. Thereafter, a copper paste prepared in the same manner as in Example 1 of Japanese Patent Laid-Open No. 138010/2000 was printed to a thickness of 40 µm in a shape having a size of 2 mm in length and 2 mm in width onto the surface of the samples 1 and 2 with a screen printing machine MT-320TVC manufactured by MICRO-TEC Co., Ltd., followed by being dried at 170°C for 20 min. in a clean oven PVC-210 manufactured by ESPEC CORP., further followed by being baked at 900°C for 15 min. in a nitrogen atmosphere in a small conveyor furnace 810-II manufactured by Koyo Lindberg to produce a copper thick-film metallized aluminum nitride substrate according to the present invention.

4. Evaluation of metallized substrate
(1) Initial adhesive strength
   A Pb60-Sn40 eutectic solder was put on a metallized part in the metallized substrate produced by the above process, and a nail head pin of 1.1 mmφ was soldered on a hot plate heated to 250°C, followed by being cooled to room temperature. The nail head pin was vertically pulled in a universal strength tester STROGRAPH-M1 manufactured by Toyo Seiki to measure the strength at which the substrate and the nail head pin were separated from each other (hereinafter referred to as "pull strength"). This strength was measured for five points for each sample. The average strength value was 132 MPa for Example 1 and 117 MPa for Example 2. In order to determine the part at which the separation occurred (hereinafter referred to as "peel mode determination"), the separated face was observed by a stereomicroscope SZ40 manufactured by Olympus Corporation at a magnification of 40 times. As a result, for sample 1, the peel mode was mainly an aluminum nitride internal fracture mode, and the remaining peel mode was a mixed mode of aluminum nitride internal fracture and solder-solder separation. For sample 2, the peel mode was an aluminum nitride internal fracture mode or a mixed mode of aluminum nitride internal fracture and solder-solder separation.

Separately, a metallized substrate was produced in the same manner as described above. A 1 µm- Ni/P layer was plated electrolessly on the copper layer in the metallized substrate, and the peel test was carried out in the same manner as described above. As a result, the pull strength (5-point average) was 125 MPa in the case where the substrate corresponding to sample 1 was used, and was 88 MPa in the case where the substrate corresponding to sample 2 was used.

(2) Adhesion durability
A metallized substrate produced in the same manner as described above was subjected to a 1000-cycle test with a thermal shock resistance tester TSV-40S manufactured by ESPEC CORP. in which one cycle consisted of -50°C ~ 125°C ~ -50°C (exposure time: 10 min.) (hereinafter referred to as "heat cycle test"). Thereafter, the pull strength was measured for five points for each sample. As a result, the average value was 130 MPa for Example 1 and was 111 MPa for Example 2. Further, the peel mode determination was carried out. As a result, in both the Examples, the peel mode was an aluminum nitride internal fracture mode or a mixed mode of aluminum nitride internal fracture and solder-solder separation.

Example 3 (Example of new oxidation process in which degassing treatment is not carried out and the partial pressure of oxygen in initial contact period falls within suitable range)
An aluminum nitride substrate in a plate form having a size of 50. 8 mm in length, 50.8 mm in width, and 0.635 mm in thickness and a surface roughness Ra of not more than 0.05 µm (SH 15, manufactured by TOKUYAMA Corp.) was introduced into a high-temperature atmosphere furnace comprising a mulite ceramic having an inner diameter of 75 mm and a length of 1100 mm as a furnace tube (SUPER BURN rebuilt type, manufactured by MOTOYAMA Co., Ltd.). The furnace was heated to 1200°C (heating up rate: 3.3°C/min.) under the flow of nitrogen gas (purity 99.99995%, dew point -80°C) into the furnace at a flow rate of 2 (l/min.). After it was confirmed that the temperature around the substrate reached 1200°C, the flow of nitrogen gas was stopped, and, instead, oxygen gas (purity 99.999%, dew point -80°C) was flowed at a flow rate of 1 (l/min.), and this condition was held for one hr to oxidize the surface of the aluminum nitride substrate. After the completion of oxidation, the substrate was cooled to room temperature (cooling down rate: 3.3°C/min.) to provide a surface oxidized aluminum nitride substrate according to the present invention.

At the same time as the start of the heating, gas discharged from the furnace was introduced into a gas chromatograph (personal gas chromatograph GC-8A, manufactured by Shimadzu Seisakusho Ltd.) and was analyzed for components over time. During heating, very small amounts of oxygen and water in addition to nitrogen were detected. The amount of oxygen and the amount of water contained in gas discharged when the substrate temperature reached 300°C, were quantitatively determined using a separately prepared calibration curve. As a result, the concentration of oxygen and the concentration of water were 1.2 mmol/m³ (0.0027 vol. %) and 1.0 mmol/m³ (0.0022 vol.%), respectively. It is considered that, since the sum of both the concentrations exceeded 0.5 mmol/m³, cells (or voids) were produced in a part of the oxide layer around the boundary of the oxide layer and the underlying material. Further, when 10 min. elapsed from the start of flow of oxygen into the furnace, the waste gas was analyzed. As a result, in addition to oxygen as the flow gas, nitrogen considered to have been produced in the reaction process was detected. The height of the nitrogen peak became the highest value after the start of oxygen flow and reduced with the elapse of the temperature holding time. The partial pressure of oxygen gas in a portion around the sample 2 min. and 3 min. after the start of introduction of oxygen was determined from a nitrogen peak reduction pattern and a separately prepared calibration curve. As a result, the partial pressure 2 min. after the start of introduction of oxygen and the partial pressure 3 min. after the start of introduction of oxygen were 28 kPa and 47 kPa, respectively.

The surface oxidized aluminum nitride substrate (sample) was analyzed by X-ray diffractometry (XRD), a scanning electron microscope (SEM) and a transmission electron microscope (TEM) in the same manner as in Examples 1 and 2. As a result, it was confirmed from the diffraction pattern obtained in XRD measurement that, for all the samples, the oxide layer was formed of α-alumina. The sample surface was observed by SEM. As a result, it was found that there was no specific crack, and the oxide layer was very dense. Further, the cross-section of the sample oxide layer was observed by TEM. As a result, voids or cells were present over the whole oxide layer. A metallized substrate was produced in the same manner as in the copper thick film metallization process in Examples 1 and 2, and the initial adhesive strength was measured. As a result, the pull strength (five-point average) was 98 MPa, and the peel mode was mainly a mixed mode of aluminum nitride internal fracture and solder-solder separation while the remaining peel mode was an aluminum nitride internal fracture mode. After the heat cycle test, the pull strength (five-point average) was 92 MPa, and the peel mode was a mixed mode of aluminum nitride internal fracture and solder-solder separation, or an aluminum nitride internal fracture mode. Separately, a metallized substrate was produced in the same manner as described above. A 1 µm Ni/P layer was plated electrolessly on the copper layer in the metallized substrate, and the peel test was carried out in the same manner as described above. As a result, the pull strength (5-point average) was 85 MPa.

Example 4 (Example of new oxidization process in which no degassing treatment is carried out and the partial pressure of oxygen in an initial period of contact is outside suitable range)
An aluminum nitride substrate in a plate form having a size of 50.8 mm in length, 50.8 mm in width, and 0.635 mm in thickness and a surface roughness Ra of not more than 0. 05 µm (SH 15, manufactured by TOKUYAMA Corp.) was heated to 1200°C (heating up rate: 3.3°C/min.) under the flow of nitrogen gas (purity 99.99995%, dew point -80°C) at a flow rate of 2 (l/min.) without degassing treatment using the same apparatus as in Example 1. After it was confirmed that the temperature around the substrate reached 1200°C, the flow of nitrogen gas was stopped. The inside of the furnace was evacuated by a rotary vacuum pump to not more than 50 Pa. Thereafter, the pressure in the inside of the furnace was rapidly increased by oxygen gas (purity 99.999%, dew point -80°C) to the atmospheric pressure while replacing the atmosphere within the furnace by the oxygen gas, and the oxygen gas was flow into the furnace at a flow rate of 2 (l/min.), and this condition was held for 5 hr to oxidize the surface of the aluminum nitride substrate. After the completion of oxidation, the substrate was cooled to room temperature (cooling down rate: 3.3°C/min.) to provide a surface oxidized aluminum nitride substrate.

The surface oxidized aluminum nitride substrate (sample) was analyzed by X-ray diffractometry (XRD), a scanning electron microscope (SEM) and a transmission electron microscope (TEM) in the same manner as in Example 1. As a result, it was confirmed from a diffraction pattern obtained by XRD measurement that, for all the samples, the oxide layer was formed of α-alumina. Further, the oxide layer had a thickness of 3500 nm on average. The surface observation by SEM revealed that not only a ridge-like streak pattern but also a crack, which is not the specific crack, was observed on the surface of the oxide layer. Further, the observation of the cross-section of the sample by TEM revealed that elliptical cells (or voids) were present in all the oxide layers. Further, unlike Examples 1, 2, and 3, cells were also observed in a part of the oxide layer around the boundary of the oxide layer and the underlying material. For the sample thus obtained, a metallized substrate was produced in the same manner as in Example 1, and the initial adhesive strength was measured. As a result, the pull strength (five-point average) was 86 MPa, and the peel mode was mainly a mixed mode of aluminum nitride internal fracture and solder-solder separation while the remaining peel mode was an aluminum nitride internal fracture mode. After the heat cycle test, the pull strength (five-point average) was 79 MPa, and the peel mode was a mixed mode of aluminum nitride internal fracture and solder-solder separation, or an aluminum nitride internal fracture mode. Separately, a metallized substrate was produced in the same manner as described above. A 1 µm- Ni/P layer was plated electrolessly on the copper layer in the metallized substrate, and the peel test was carried out in the same manner as described above. As a result, the pull strength (5-point average) was 80 MPa.

Examples 5 and 6 (Examples of new oxidation process in which degassing treatment is carried out and the partial pressure of oxygen in the initial period of contact is outside suitable range)
An aluminum nitride substrate in a plate form having a size of 50. 8 mm in length, 50.8 mm in width, and 0.635 mm in thickness and a surface roughness Ra of not more than 0. 05 µm (SH 15, manufactured by TOKUYAMA Corp.) was heated to 1200°C using the same apparatus as in Example 1 under the same conditions as in Example 1. After it was confirmed that the temperature around the substrate reached 1200°C, the flow of nitrogen gas was stopped. The inside of the furnace was again evacuated by a rotary vacuum pump to not more than 50 Pa. Thereafter, the pressure in the inside of the furnace was rapidly increased by oxygen gas (purity 99.999%, dew point -80°C) to the atmospheric pressure while replacing the atmosphere within the furnace by the oxygen gas, and the oxygen gas was flow into the furnace at a flow rate of 2 (l/min.), and this condition was held for 5 hr to oxidize the surface of the aluminum nitride substrate. After the completion of oxidation, the substrate was cooled to room temperature (cooling down rate: 3.3°C/min.) to provide a surface oxidized aluminum nitride substrate (Example 5). Alternatively, a surface oxidized aluminum nitride substrate was produced in quite the same manner as in Example 5, except that the increase in pressure was carried out using an oxidizing gas prepared by mixing nitrogen gas (purity 99.99995%, dew point -80°C) and oxygen gas (purity 99.999%, dew point -80°C) together to give a partial pressure of oxygen gas of 60 kPa (Example 6).

The surface oxidized aluminum nitride substrate (sample) was analyzed by X-ray diffractometry (XRD), a scanning electron microscope (SEM) and a transmission electron microscope (TEM) in the same manner as in Example 1. As a result, it was confirmed from a diffraction pattern obtained by XRD measurement that, for all the samples, the oxide layer was formed of α-alumina. The thickness of the oxide layer was 3100 nm on average for the sample of Example 5 and was 2800 nm on average for the sample of Example 6. The surface observation by SEM revealed that, for both the samples, not only a ridge-like streak pattern but also a crack, which is not the specific crack, was observed on the surface of the oxide layer. Further, the observation of the cross-section of the sample by TEM revealed that elliptical cells (or voids) were present in all the oxide layers. Further, unlike Examples 1, 2, and 3, in all the sample, cells were also observed in a part of the oxide layer around the boundary of the oxide layer and the underlying material. For the samples thus obtained, a metallized substrate was produced in the same manner as in Example 1, and the initial adhesive strength was measured. As a result, the pull strength (five-point average) was 89 MPa (Example 5) and 81 MPa (Example 6), and, for both the samples, the peel mode was mainly a mixed mode of aluminum nitride internal fracture and solder-solder separation while the remaining peel mode was an aluminum nitride internal fracture mode. After the heat cycle test, the pull strength (five-point average) was 81 MPa (Example 5) and 77 MPa (Example 6), and, for both the samples, the peel mode was a mixed mode of aluminum nitride internal fracture and solder-solder separation, or an aluminum nitride internal fracture mode. Separately, metallized substrates were produced in the same manner as described above. A 1 µm- Ni/P layer was plated electrolessly on the copper layer in the metallized substrates, and the peel test was carried out in the same manner as described above. As a result, the pull strength (5-point average) was 70 MPa (Example 5) and 80 MPa (Example 6).

Comparative Examples 1 and 2 (Example of conventional oxidation process)
An aluminum nitride substrate in a plate form having a size of 50.8 mm in length, 50.8 mm in width, and 0. 635 mm in thickness and a surface roughness Ra of not more than 0.5 µm (SH 30, manufactured by TOKUYAMA Corp.) was introduced into a high-temperature atmosphere furnace comprising a mulite ceramic having an inner diameter of 75 mm and a length of 1100 mm as a furnace tube (SUPER BURN rebuilt type, manufactured by MOTOYAMA Co., Ltd.). The furnace was heated to 1200°C (heating up rate: 3.3°C/min.) under the flow of air at a flow rate of 2 (l/min.). After the temperature around the substrate was confirmed to reach 1200°C, the temperature was held at this temperature for 0.5 hr to oxidize the surface of the aluminum nitride substrate. After the completion of oxidation, the substrate was cooled to room temperature (cooling down rate: 3.3°C/min.) to provide a surface oxidized aluminum nitride substrate (Comparative Example 1). Separately, a surface oxidized aluminum nitride material was produced in the same manner as in Comparative Example 1, except that the holding temperature and the holding time were changed to 1300°C and 10 hr, respectively (Comparative Example 2).

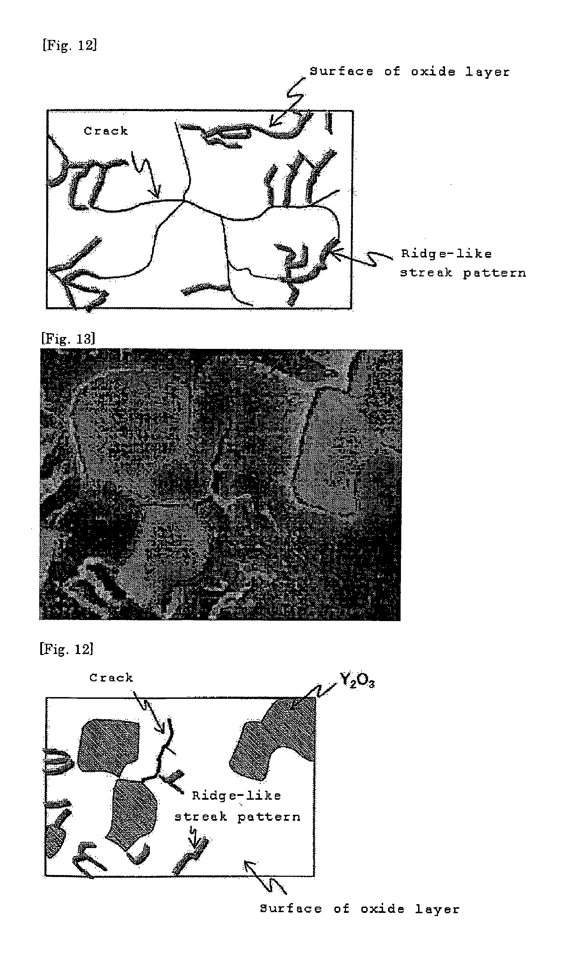

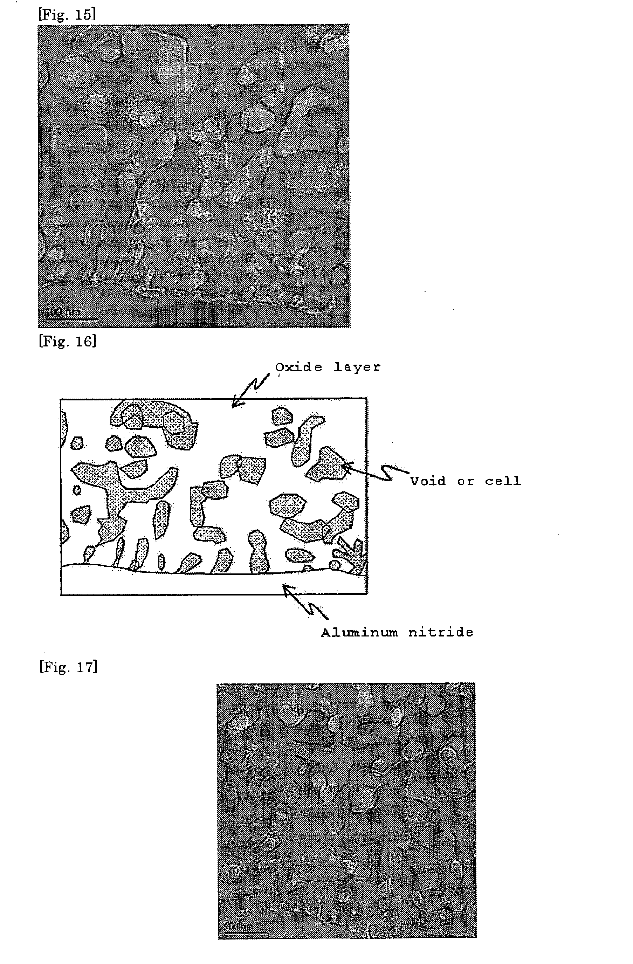

The surface oxidized aluminum nitride substrates thus obtained were analyzed by X-ray diffractometry (XRD), a scanning electron microscope (SEM) and a transmission electron microscope (TEM) in the same manner as in Examples 1 and 2. As a result, it was confirmed from the diffraction pattern obtained in XRD measurement that, for all the samples, the oxide layer was formed of α-alumina. The average thickness of the oxide layer was 1500 nm on average for the sample of Comparative Example 1 and was 18000 nm on average for the sample of Comparative Example 2. Typical photographs of the samples of Comparative Examples 1 and 2 by SEM observation are shown in Figs. 11 and 13, and illustrations thereof are shown in Figs. 12 and 14. As shown in Figs. 11 and 13, for both the samples, in addition to a ridge-like streak pattern, a specific crack was observed on the surface of the oxide layer. For cracks present on the surface of the oxide layer in each sample, "w", "1" and "w/l" in crack units having the largest" w/l" value were determined based on the SEM photograph and were found to be w = 120 nm, 1 = 880 nm, and w/1 = 0.14 for the sample of Comparative Example 1 and were found to be w = 140 nm, 1 = 760 nm, and w/1 = 0.18 for the sample of Comparative Example 2. Further, the same observation was carried out for arbitrarily selected 50 visual fields (visual fields having a radius of 30000 nm). As a result, the number of observed specific cracks was 35 in total for Comparative Example 1 and 38 in total for Comparative Example 2. Typical photographs of the samples of Comparative Examples 1 and 2 by TEM are shown in Figs. 15 and 17, and illustrations thereof are shown in Figs. 16 and 18. As shown in Figs. 15 and 17, elliptical cells (or voids) were observed in all the oxide layers. Further, unlike Examples 1 and 2, for all the samples, cells were also observed in a part of the oxide layer around the boundary between the oxide layer and the underlying material. Further, the weight reduction in the alkali resistance test of the sample of Comparative Example 1 was 82 (g/m²).

Next, metallized substrates were produced in the same manner as in the step of copper thick-film metallization in Examples 1 and 2, and the initial adhesive strength of the metallized substrates thus obtained were measured. As a result, the pull strength (five-point average) was 62 MPa for Comparative Example 1 and 47 MPa for Comparative Example 2. For Comparative Example 1, the peel mode was mainly a thick film-substrate separation mode while the remaining peel mode was a mixed mode of thick film-substrate separation and solder-thick film separation. For Comparative Example 2, the peel mode was an alumina internal fracture mode or a thick film-substrate separation mode. Further, for Comparative Example 1, a 1 µm- Ni/P layer was formed electrolessly on the copper metallized layer in the same manner as in Example 1, and the adhesive strength thereof was measured. As a result, the pull strength (five-point average) was 50 MPa. For reference, an aluminum nitride substrate not subjected to oxidation treatment was metallized in the same manner as described above, and the peel test was carried out for the metallized substrate. As a result, the initial pull strength (five-point average) of the metallized layer formed of only the copper layer was 57 MPa, and the pull strength (five-point average) after the electroless plating was 40 MPa.

Further, the heat cycle test was carried out in the same manner as in Examples 1 and 2. As a result, the pull strength (five-point average) was 52 MPa for Comparative Example 1 and was 36 MPa for Comparative Example 2. For Comparative Example 1, the peel mode was only a thick film-substrate separation mode, and, for Comparative Example 2, the peel mode was an alumina internal fracture mode or a thick film-substrate separation mode. The results of Examples 1 to 6 and Comparative Examples 1 and 2 are summarized in Table 1.

**[Table 1]**

| | Sample No. (MPa) | Initial adhesive strength | | Determination of separation | Achesive strength after heat cycle test | | Determination of separation | Adhesive strength after plating (Ni-P) | |
|---|---|---|---|---|---|---|---|---|---|
| | | 141 | Average | mode | (MPa) | Average | mode | (MPa) | Average |
| Example 1 | 1 | 141 | 132 | A | 123 | 130 | A | 122 | 125 |
| | 2 | 127 | | A | 138 | | A | 138 | |
| | 3 | 133 | | A | 128 | | B | 128 | |
| | 4 | 138 | | A | 128 | | B | 124 | |
| | 5 | 122 | | B | 138 | | A | 135 | |
| Example 2 | 1 | 117 | 117 | A | 122 | 111 | B | 123 | 88 |
| | 2 | 105 | | B | 114 | | A | 114 | |
| | 3 | 128 | | A | 109 | | A | 109 | |
| | 4 | 120 | | B | 113 | | A | 123 | |
| | 5 | 116 | | A | 107 | | B | 107 | |
| Example 3 | 1 | 97 | 98 | B | 82 | 92 | B | 82 | 85 |
| | 2 | 110 | | A | 96 | | B | 96 | |
| | 3 | 102 | | B | 88 | | B | 89 | |
| | 4 | 89 | | B | 101 | | A | 101 | |
| | 5 | 94 | | B | 95 | | A | 95 | |
| Example 4 | 1 | 97 | 86 | A | 77 | 79 | B | 82 | 80 |
| | 2 | 88 | | B | 79 | | B | 75 | |
| | 3 | 91 | | B | 82 | | B | 84 | |
| | 4 | 72 | | A | 74 | | A | 77 | |
| | 5 | 82 | | B | 83 | | B | 82 | |
| Example 5 | 1 | 86 | 89 | B | 77 | 81 | B | 83 | 78 |
| | 2 | 93 | | A | 83 | | B | 76 | |
| | 3 | 91 | | B | 81 | | C | 72 | |
| | 4 | 84 | | C | 83 | | B | 79 | |
| | 5 | 91 | | B | 81 | | B | 80 | |
| Example 6 | 1 | 88 | 85 | A | 73 | 77 | B | 78 | 80 |
| | 2 | 85 | | B | 79 | | B | 83 | |
| | 3 | 92 | | A | 84 | | B | 80 | |
| | 4 | 82 | | B | 76 | | B | 82 | |
| | 5 | 88 | | B | 71 | | B | 77 | |
| Comparative Example 1 | 1 | 68 | 62 | D | 43 | 52 | D | 43 | 50 |
| | 2 | 70 | | E | 55 | | D | 55 | |
| | 3 | 58 | | D | 61 | | D | 61 | |
| | 4 | 66 | | D | 44 | | D | 44 | |
| | 5 | 50 | | D | 56 | | D | 56 | |
| Comparative Example 2 | 1 | 45 | 47 | F | 28 | 36 | D | 28 | - |
| | 2 | 46 | | D | 37 | | D | 37 | |
| | 3 | 58 | | F | 33 | | F | 33 | |
| | 4 | 40 | | F | 37 | | D | 37 | |
| | 5 | 48 | | D | 43 | | F | 43 | |

| | | | | | | | | | |
|---|---|---|---|---|---|---|---|---|---|
| Determination of separation mode A: AlN internal fracture B: AlN internal fracture/between solder and solder C: Between solder and solder D: Between thick film and substrate E: Between thick film and substrate/between solder and thick film F: Alumina internal fracture | | | | | | | | | |

### INDUSTRIAL APPLICABILITY

In the metallized shaped article according to the present invention, the oxide layer in the "non-oxide ceramic shaped article having an oxide layer on its surface" as a layer underlying the metal layer has very high quality, and, thus, the adhesion between the metal layer and the shaped article is very high. Further, metallization techniques for oxide ceramics are also applicable. Therefore, as compared with the conventional non-oxide ceramic metallized shaped article, the reliability in the use of the metallized shaped article, for example, as electronic circuit boards or heaters is significantly improved. Further, according to the production process of the present invention, the above excellent metallized shaped article according to the present invention can be produced stably with high efficiency.

The Peltier element according to the present invention uses a non-oxide ceramic substrate having a high-quality oxide layer on its surface. Therefore, the Peltier element is characterized in that, despite the fact that the substrate is composed mainly of a non-oxide ceramics, the adhesion between the metal layer constituting a conductor pattern and the substrate is very good and, at the same time, durability against heat cycle is high. Further, since the oxide layer functions also as a protective layer, even when a plating method is applied, neither damage to or a deterioration in the substrate nor a plating-derived lowering in adhesive strength of the metallized layer occurs. Therefore, regarding the Peltier element according to the present invention, in producing this element, more specifically in producing a ceramic substrate having a conductor pattern (a metallized substrate), a new metallization process can be adopted in which a conductor circuit pattern is formed using a copper thick-film paste by a printing method and a metal layer as a layer of barrier against a solder layer is further formed threon by a plating method.

Further, since the new metallization process adopts a thick-film method and a plating method which are simple in operation and low in cost, the production process according to the present invention using the metallization process can provide a Peltier element simply at low cost.
Furthermore, since the oxide layer is strongly adhered to the underlying non-oxide ceramics, the effect can be maintained for a long period of time even when the Peltier element is used under severe conditions, for example, under such conditions that a change in temperature in service environment is significant.

## Claims

1. A process for producing a metallized ceramic shaped article, comprising: a heating step of heating a non-oxide ceramic shaped article to a temperature at or above a temperature, which is 300°C below the oxidation start temperature of the non-oxide ceramics, without substantial dissolution of oxygen in a solid solution form during heating; an oxidation step of bringing the non-oxide ceramic shaped article heated in the heating step into contact with an oxidizing gas and then holding the non-oxide ceramic shaped article at a temperature above the oxidation start temperature of the non-oxide ceramics to oxidize the surface of the non-oxide ceramic shaped article and thus to form an oxide layer on the surface of the non-oxide ceramic shaped article; and a metallization step of forming a metal layer on the surface of the oxide layer in the non-oxide ceramic shaped article having an oxide layer on its surface produced in the oxidation step.

2. The method according to claim 1, wherein the heating step comprises the steps of:
(I) introducing the non-oxide ceramic shaped article into a furnace, then discharging an oxidizing substance adsorbed or sorbed to the non-oxide ceramic shaped article and to a furnace material outside of the furnace, so as to regulate an oxidizing gas content in the atmosphere within the furnace to be not more than 0.5 mmol in terms of total number of moles of the oxidizing gas per m³ of the inside of the furnace; and
(II) heating the non-oxide ceramic shaped article to a temperature at or above a temperature, which is 300°C below the oxidation start temperature of the non-oxide ceramics, while maintaining the atmosphere in the furnace having an oxidizing gas content of not more than 0.5 mmol in terms of total number of moles of the oxidizing gas per m³ of the inside of the furnace; and wherein
when bringing the non-oxide ceramic shaped article into contact with the oxidizing gas in the oxidation step, until at least 2 min. elapses after the arrival of the temperature of the non-oxide ceramic shaped article at or above the oxidation start temperature thereof, the pressure or partial pressure of the oxidizing gas is maintained at not more than 50 kPa.

3. The process according to claim 1 or 2, wherein the metallization step comprises plating treatment.

4. A metallized ceramic shaped article produced by the method of any one of claims 1 to 3.

5. A metallized ceramic shaped article comprising: a ceramic shaped article comprising a non-oxide ceramic shaped article composed mainly of a nitride or carbide of a metal or semimetal and an oxide layer formed of an oxide of an element identical to the metal or semimetal element provided on the surface of the non-oxide ceramic shaped article; and a metal layer provided on the oxide layer, wherein, when a branched crack is divided into a crack unit located between adjacent branch points and crack units extending from the crack end to the nearest branch point, a branched crack having a crack unit simultaneously meeting a "w" value of not less than 20 nm, an "1" value of not less than 500 nm and a "w/l" value of not less than 0.02, wherein "l" (nm) represents the length of each crack unit, and "w" (nm) represents the maximum width of each crack unit, is substantially absent on the surface of the oxide layer.

6. A metallized ceramic shaped article comprising: a ceramic shaped article comprising a non-oxide ceramic shaped article composed mainly of a nitride or carbide of a metal or semimetal and a 0.1 to 100 µm-thick oxide layer formed of an oxide of an element identical to the metal or semimetal element provided on the surface of the non-oxide ceramic shaped article; and a metal layer provided on the oxide layer, wherein voids are substantially absent in the oxide layer in its region in a thickness of at least 20 nm from the boundary of the non-oxide ceramic layer and the oxide layer.

7. A Peltier element comprising: a pair of ceramic substrates each having a conductor pattern on its surface and disposed so as to face each other; a thermoelectric material part comprising P-type thermoelectric materials and N-type thermoelectric materials arranged alternately between the pair of ceramic substrates; an electrode disposed between the thermoelectric material part and one of the ceramic substrates; and an electrode disposed between the thermoelectric material part and the other ceramic substrate, said electrodes being disposed so that the P-type thermoelectric materials and N-type thermoelectric materials constituting the thermoelectric material part are alternately connected electrically, said electrodes being each connected electrically to the conductor pattern in the adjacent ceramic substrate, wherein
the ceramic substrate comprises: a non-oxide ceramic substrate composed mainly of a nitride or carbide of a metal or semimetal and an oxide layer formed of an oxide of an element identical to the metal or semimetal element provided on the surface of the non-oxide ceramic substrate, and, when a branched crack is divided into a crack unit located between adjacent branch points and crack units extending from the crack end to the nearest branch point, a branched crack having a crack unit simultaneously meeting a "w" value of not less than 20 nm, an "1" value of not less than 500 nm and a "w/l" value of not less than 0.02, wherein "1" (nm) represents the length of each crack unit, and "w" (nm) represents the maximum width of each crack unit, is substantially absent on the surface of the oxide layer.

8. A Peltier element comprising: a pair of ceramic substrates each having a conductor pattern on its surface and disposed so as to face each other; a thermoelectric material part comprising P-type thermoelectric materials and N-type thermoelectric materials arranged alternately between the pair of ceramic substrates; an electrode interposed between the thermoelectric material part and one of the ceramic substrates; and an electrode interposed between the thermoelectric material part and the other ceramic substrate, said electrodes being disposed so that the P-type thermoelectric materials and N-type thermoelectric materials constituting the thermoelectric material part are alternately connected electrically, said electrodes being each connected electrically to the conductor pattern in the adjacent ceramic substrate, wherein
the ceramic substrate comprises: a ceramic substrate comprising a non-oxide ceramic substrate composed mainly of a nitride or carbide of a metal or semimetal; and a 0.1 to 100 µm-thick oxide layer formed of an oxide of an element identical to the metal or semimetal element provided on the surface of the non-oxide ceramic substrate, and voids are substantially absent in the oxide layer in its region in a thickness of at least 20 nm from the boundary of the non-oxide ceramic layer and the oxide layer.

9. A process for producing a Peltier element, said Peltier element comprising: a pair of ceramic substrates each having a conductor pattern on its surface and disposed so as to face each other; a thermoelectric material part comprising P-type thermoelectric materials and N-type thermoelectric materials arranged alternately between the pair of ceramic substrates; an electrode interposed between the thermoelectric material part and one of the ceramic substrates; and an electrode interposed between the thermoelectric material part and the other ceramic substrate, the electrodes being disposed so that the P-type thermoelectric materials and N-type thermoelectric materials constituting the thermoelectric material part are alternately connected electrically, the electrodes being each connected electrically to the conductor pattern in the adjacent ceramic substrate, said process comprising the following steps A, B, and C,
step A: a step of providing a thermoelectric material member comprising alternately arranged P-type thermoelectric materials and N-type thermoelectric materials, wherein the top face of each of the thermoelectric materials is connected electrically to the top face of the thermoelectric material adjacent to one side thereof through an electrode, and, at the same time, the bottom face of each of the thermoelectric materials is connected electrically to the bottom face of the thermoelectric material adjacent to the other side thereof through an electrode,
step B: a step of providing a pair of ceramic substrates each having a conductor pattern on its surface, the conductor pattern in each of the ceramic substrates being provided so that, when the thermoelectric material member is held between the ceramic substrates, the conductor pattern is connected electrically to the electrode in the thermoelectric material member, and
step C: a step of disposing the thermoelectric material member between the pair of ceramic substrates and soldering the electrodes in the thermoelectric material member to the conductor pattern in each of the ceramic substrates, wherein
said process further comprising the following steps for the production of the ceramic substrates having a conductor pattern on the surface thereof,
step D: a heating step of heating a non-oxide ceramic substrate to a temperature at or above a temperature, which is 300°C below the oxidation start temperature of the non-oxide ceramics, without substantial dissolution of oxygen in a solid solution form during heating;
step E: an oxidation step of bringing the non-oxide ceramic substrate heated in the step D into contact with an oxidizing gas and then holding the non-oxide ceramic substrate at a temperature above the oxidation start temperature of the non-oxide ceramics to oxidize the surface of the non-oxide ceramic substrate and thus to form an oxide layer on the surface of the non-oxide ceramic substrate; and
step F: a step of forming a pattern of copper or a metal layer composed mainly of copper on the oxide layer in the non-oxide ceramic substrate having an oxide layer on its surface produced in the step E by a thick-film forming method and then forming a layer of a metal different from the metal constituting the metal layer by a plating method onto the pattern.

10. A Peltier element comprising: a pair of ceramic substrates each having a conductor pattern on its surface and disposed so as to face each other; a thermoelectric material part comprising P-type thermoelectric materials and N-type thermoelectric materials arranged alternately between the pair of ceramic substrates; an electrode disposed between the thermoelectric material part and one of the ceramic substrates; and an electrode disposed between the thermoelectric material part and the other ceramic substrate, said first and second electrodes being disposed so that the P-type thermoelectric materials and N-type thermoelectric materials constituting the thermoelectric material part are alternately connected electrically, said electrodes being each connected electrically to the conductor pattern in the adjacent ceramic substrate, wherein
the ceramic substrate is "a non-oxide ceramic substrate having an oxide layer on its surface" produced by a process comprising the following steps D and E,
step D: a heating step of heating a non-oxide ceramic substrate to a temperature at or above a temperature, which is 300°C below the oxidation start temperature of the non-oxide ceramics, without substantial dissolution of oxygen in a solid solution form during heating; and
step E: an oxidation step of bringing the non-oxide ceramic substrate heated in the step D into contact with an oxidizing gas and then holding the non-oxide ceramic substrate at a temperature above the oxidation start temperature of the non-oxide ceramics to oxidize the surface of the non-oxide ceramic substrate and thus to form an oxide layer on the surface of the non-oxide ceramic substrate.

11. The Peltier element according to claim 10, wherein the step D comprises the steps of:
(I) introducing the non-oxide ceramic shaped article into a furnace, then discharging an oxidizing substance adsorbed or sorbed to the non-oxide ceramic substrate and to a furnace material outside of the furnace, so as to regulate an oxidizing gas content in the atmosphere within the furnace to be not more than 0.5 mmol in terms of total number of moles of the oxidizing gas per m³ of the inside of the furnace; and
(II) heating the non-oxide ceramic substrate to a temperature at or above a temperature, which is 300°C below the oxidation start temperature of the non-oxide ceramics, while maintaining the atmosphere in the furnace having an oxidizing gas content of not more than 0.5 mmol in terms of total number of moles of the oxidizing gas per m³ of the inside of the furnace; and
when bringing the non-oxide ceramic substrate into contact with the oxidizing gas in the oxidation step E, until at least 2 min. elapses after the arrival of the temperature of the non-oxide ceramic shaped article at or above the oxidation start temperature thereof, the pressure or partial pressure of the oxidizing gas is maintained at not more than 50 kPa.
